# EUROPEAN PATENT APPLICATION

(11) **EP 1 844 946 A1**
(43) Date of publication of application: **17.10.2007**
(21) Application number: 05774555.6
(22) Date of filing: 24.08.2005
(51) Int. Cl.: B41N 1/14, G03F 7/00, G03F 7/004

(54) **LITHOGRAPHIC PRINTING PLATE ORIGINAL PLATE AND LITHOGRAPHIC PRINTING METHOD**

(30) Priority: 31.01.2005 JP 2005022605
(71) Applicant: FUJIFILM Corporation, Minato-ku Tokyo 106-0031 (JP)
(72) Inventor: SONOKAWA, Koji c/o FUJIFILM Corporation, Haibara-gun, Shizuoka (JP); MITSUMOTO, Tomoyoshi c/oFUJIFILM Corporation, Haibara-gun, Shizuoka (JP); YAMASAKI, Sumiaki c/oFUJIFILM Corporation, Haibara-gun, Shizuoka (JP)
(74) Representative: HOFFMANN EITLE
(86) International application number: PCT/JP2005/015371
(87) International publication number: WO 2006/080107

(57) **Abstract**

To provide a lithographic printing plate precursor capable of obtaining a plenty of sheets of good printed matters with practical energy dosage, which is excellent in on-press developing property and press life, and capable of reducing pollution of fountain solution, and provide a lithographic printing method. The lithographic printing plate precursor comprises a support having provided thereon an image-recording layer, which lithographic printing plate precursor is mounted on a printing press and imagewise exposed, or mounted on the printing press after imagewise exposure, and then developed by feeding printing ink and/or a fountain solution, wherein at least a part of the unexposed part of the image-recording layer is not dissolved in the printing ink, the fountain solution or both of them, and removed by falling out of film, and the invention provides a lithographic printing method using the same.

## Description

### Technical Field

The present invention relates to a lithographic printing plate precursor and a lithographic printing method. More specifically, the invention relates to a lithographic printing plate precursor capable of what is called direct plate-making, i.e., capable of directly making a printing plate by scanning with laser beams on the basis of digital signals of a computer and the like, and a lithographic printing method of developing the lithographic printing plate precursor on a printing press and performing printing without going through a development process.

### Background Art

A lithographic printing plate generally comprises an ink-receptive image part that receives ink and a hydrophilic non-image part that receives a fountain solution in a printing process. Lithographic printing is a printing method of making difference in an ink-adhering property on the surface of a lithographic printing plate with the ink-receptive image part of the lithographic printing plate as the ink-receptive part and the hydrophilic non-image part as the fountain solution- receptive part (an ink-repellent part) by making use of the natures of water and oil ink of repelling to each other, and adhering ink only on the image part, and transferring the ink to the material to be printed, e.g., paper. For manufacturing the lithographic printing plate, a lithographic printing plate precursor (a PS plate) comprising a hydrophilic support having provided thereon an ink-receptive photosensitive resin layer (an image-recording layer) has so far been widely used. In general, a lithographic printing plate is obtained by a plate-making method of exposing a lithographic printing plate precursor through an original image of a lith film and the like, and then, for leaving an image-recording layer of an image part behind, dissolving and eliminating an image-recording layer of a non-image part with an alkali developing solution or an organic solvent to thereby bare a hydrophilic support surface.

In a conventional plate-making process of a lithographic printing plate precursor, a process of dissolving and eliminating a non-image part with a developing solution and the like corresponding to the image-recording layer is necessary after exposure, but the exclusion or simplification of such an additional wet process is one of the subjects in the industry. Since the discard of waste solutions discharged with wet processes is a particularly great interest in the industry at large in recent years from the consideration of the global environment, the solution of the above problem is increasingly desired.

Concerning this requirement, as one of the simple plate-making methods, a method called on-press development (or a non-processing type) is proposed, which is a method of using an image-recording layer capable of elimination of a non-image part of a lithographic printing plate precursor in an ordinary printing process, and removing a non-image part after exposure on a printing press to obtain a lithographic printing plate. As the specific examples of on-press development, e.g., a method of using a lithographic printing plate precursor having an image-recording layer soluble in, e.g., a fountain solution, an ink solvent, or an emulsified product of a fountain solution and ink, a method of mechanically removing an image-recording layer by the contact with the rollers and the blanket of a press, and a method of mechanically removing an image-recording layer by the contact with the rollers and the blanket after weakening the cohesive strength of the image-recording layer or the adhesive strength of the image-recording layer and a support by the permeation of a fountain solution and an ink solvent are exemplified. Incidentally in the invention, unless otherwise indicated, "development process" means a process of removing the unexposed part of an image-recording layer of a lithographic printing plate precursor by being brought into contact with a liquid (generally an alkali developing solution) to thereby bare the hydrophilic support surface with an apparatus other than a printing press (generally an automatic processor), and "on-press development" means a method and a process of removing the unexposed part of an image-recording layer of a lithographic printing plate precursor by being brought into contact with a liquid (generally printing ink and/or a fountain solution) to thereby bare the hydrophilic support surface with a printing press.

On the other hand, in recent years, digitized techniques of electronically processing image data, accumulating and outputting with a computer have prevailed, and various novel image output systems corresponding to these digitized techniques have been put to practical use. Under such circumstances, a computer-to-plate technique of directly making a lithographic printing plate is attracting public attention, which technique comprises scanning exposing a lithographic printing plate precursor with high convergent radiant rays such as laser beams carrying digitized image data without using a lith film. With such a tendency, it is one of important technical subjects to obtain a lithographic printing plate precursor well adapted to such a technique.

As described above, the simplification of plate-making operation, and the realization of dry system and non-processing system have been more and more required in recent years from both aspects of global environmental protection and the adaptation for digitization.

Since high output lasers such as semiconductor lasers and YAG lasers radiating infrared rays of the wavelengths of from 760 to 1,200 nm are inexpensively available nowadays, methods of using these high output lasers as the image recording light sources are now promising as the manufacturing method of a lithographic printing plate by scanning exposure easily introducible into digitized techniques. For example, by performing a plate-making process by on-press development with an image-recording layer that is insolubilized or solubilized by exposure with a high output laser, and making the exposed image-recording layer imagewise a lithographic printing plate, a printing system that an image is not influenced even if exposed to room light after exposure becomes possible, and the realization is desired.

As such a lithographic printing plate precursor, for example, a lithographic printing plate precursor comprising a hydrophilic support having provided thereon an image-forming layer containing hydrophobic thermoplastic polymer particles dispersed in a hydrophilic binder is known (e.g., patent literature 1). The printing plate of the lithographic printing plate precursor can be made according to on-press development by exposing the lithographic printing plate precursor with an infrared laser to coalesce the hydrophobic thermoplastic polymer particles by heat fusion to thereby form an image, mounting the printing plate precursor on the cylinder of a press, and feeding a fountain solution and/or ink. However, the method of forming an image by coalescence of polymer fine particles by mere heat fusion as above certainly shows a good on-press developing property, but image strength is very weak and press life is insufficient.

As an example to improve the press life of such a lithographic printing plate precursor capable of on-press development, there is proposed a lithographic printing plate precursor comprising a hydrophilic support having provided thereon a heat-sensitive layer containing microcapsules containing a compound having a functional group reactive on heating, wherein the heat-sensitive layer or a contiguous layer thereto contains an infrared absorber (patent literatures 2 and 3). As another technique for improving press life, a lithographic printing plate precursor capable of on-press development comprising a support having provided thereon a photosensitive layer containing an infrared absorber, a radical polymerization initiator and a polymerizable compound is known (patent literature 4). According to such a method of using reaction such as polymerization reaction as above, it is possible to increase image strength on account of high density in chemical bonding at the image part as compared with the image part formed by heat fusion of polymer fine particles. However, the method is still insufficient from the point of compatibility of on-press developing property with fine line reproducibility and press life.

On the other hand, there is disclosed in patent literature 5 a print developing type photosensitive lithographic printing plate comprising a hydrophilized support having provided thereon an ink-receptive photosensitive layer containing a compound having at least one addition polymerizable ethylenic double bond and a photopolymerization initiator, having peeling strength of a gummed cloth tape from the support of 500 g/cm or less obtained by a peeling strength measuring method with a gummed cloth tape. However, when peeling strength of the photosensitive layer and the support before exposure is lowered as above for the purpose of improving image reproducibility, the adhesion between the photosensitive layer and the support after exposure cannot be sufficiently improved, so that the compatibility of image reproducibility and press life is still insufficient.
Patent Literature 1 Japanese Patent No. 2938397
Patent Literature 2 JP-A-2001-277740 (The term "JP-A" as used herein refers to an "unexamined published Japanese patent application".)
Patent Literature 3 JP-A-2001-277742
Patent Literature 4 JP-A-2002-287334
Patent Literature 5 JP-A-10-333321

### Disclosure of the Invention

### Problems that the Invention Is to Solve

The invention has been done in view of the problems of the conventional art. Accordingly, an object of the invention is to provide a lithographic printing plate precursor capable of recording images directly from digital data such as computer and capable of on-press development without going through a development process, by which a plenty of sheets of good printed matters can be obtained with practical energy dosage, which is excellent in on-press developability and press life, and capable of reducing pollution of fountain solution, and another object is to provide a lithographic printing method.

### Means for Solving the Problems

The present invention is as follows.
(1) A lithographic printing plate precursor, which comprises:
   a support having provided thereon an image-recording layer,
   wherein the lithographic printing plate precursor is mounted on a printing press and imagewise exposed, or mounted on the printing press after imagewise exposure, and then developed by feeding printing ink and/or a fountain solution, and
   wherein at least a part of an unexposed part of the image-recording layer is not dissolved in the printing ink, the fountain solution or both of them, and removed by falling out of film.
(2) The lithographic printing plate precursor as described in (1) above,
   wherein the image-recording layer comprises:
   (A) an infrared absorber;
   (B) a polymerization initiator; and
   (C) a polymerizable compound.
(3) The lithographic printing plate precursor as described in (1) above,
   wherein the image-recording layer comprises:
   (B) a polymerization initiator; and
   (C) a polymerizable compound, and has photosensitivity in a range of wavelengths of from 250 to 420 mn.
(4) The lithographic printing plate precursor as described in any of (1) to (3) above,
   wherein the image-recording layer comprises microcapsules or microgel.
(5) The lithographic printing plate precursor as described in any of (1) to (4) above,
   wherein the image-recording layer further comprises (D) a binder polymer that is insoluble in the printing ink, the fountain solution or both of them in a time required for the development process.
(6) The lithographic printing plate precursor as described in any of (1) to (5) above,
   wherein an adhesive force of the image-recording layer and the support lowers in the presence of the fountain solution.
(7) A lithographic printing method, which comprises:
   (i) a process of preparing the lithographic printing plate precursor as described in any of (1) to (6) above;
   (ii) a process of mounting the lithographic printing plate precursor on a plate cylinder of a printing press and imagewise exposing, or mounting the lithographic printing plate precursor on the plate cylinder of the printing press after imagewise exposure;
   (iii) a process of removing an unexposed part of the lithographic printing plate precursor after exposure by feeding printing ink and/or a fountain solution; and
   (iv) a process of printing.
(8) The lithographic printing method as described in (7) above,
wherein, in the process (iii), at least a part of the unexposed part of the image-recording layer is removed by falling out with an inking roller of the printing press by feeding the printing ink and the fountain solution to the lithographic printing plate precursor after exposure.

### Advantage of the Invention

The invention can provide a lithographic printing plate precursor capable of obtaining a plenty of sheets of good printed matters with practical energy dosage, excellent in on-press developability and press life, and capable of reducing pollution of fountain solution, and a lithographic printing method.

### Best Mode for Carrying Out the Invention

The invention is described in detail below.

### [Lithographic Printing Plate Precursor]

### <Image-recording layer>

The image-recording layer for use in the lithographic printing plate precursor in the invention is preferably an image-recording layer containing (A) an infrared absorber, (B) a polymerization initiator, and (C) a polymerizable compound, and capable of recording upon irradiation with infrared rays, or an image-recording layer containing (B) a polymerization initiator, and (C) a polymerizable compound, and having photosensitivity in the range of wavelengths of from 250 to 420 nm. In the lithographic printing plate precursor, the exposed part of the image-recording layer is cured to form a hydrophobic (ink-receptive) area, and the unexposed part is rapidly removed from the support at the time of start of printing with a fountain solution, ink, or an emulsified product of a fountain solution and ink. That is, the image- recording layer is characterized in that it is removed by falling out without being dissolved in printing ink and/or a fountain solution.

### <Definition of film removal by falling out>

"Film removal by falling out" used in the invention means the phenomenon that a part of an image-recording layer is peeled off while it is in the state of a film different from the phenomenon that development advances by dissolution of an image-recording layer. Accordingly, the case where the size of the fallen out image recording layer component in horizontal direction (in the perpendicular direction to the film thickness direction) is greater than the film thickness of the image- recording layer is defined as the film removal by falling out.

The size in the horizontal direction is not especially restricted so long as the above condition is satisfied. However, the more the starting point of the removal by falling out of film, the more rapidly advances the on-press development, as a result the size of the fallen out image recording layer component is preferably smaller. The size is preferably from the film thickness to 5 mm, more preferably from the film thickness to 1 mm, and still more preferably from the film thickness to 100 µm. Further, of the components of the image- recording layer removed by development, the percentage of the film removal by falling out is preferably higher for the reason that the advantage of the invention becomes greater. The percentage is preferably 20% or more, more preferably 50% or more, and still more preferably 80% or more.

### <Conditions of revealing of film removal by falling out>

For revealing film removal by falling out, it is essential that at least a part of an image-recording layer is not dissolved in printing ink and/or a fountain solution within the time required for on-press development, and that the adhesion of the image-recording layer of the unexposed part with a support becomes smaller than the adhesion of the roller surface of any of the inking roller, water roller and blanket roller of a press with the outermost surface of photosensitive material (image-recording layer). Therefore, it is more preferred that (1) the binder of an image-recording layer that is insoluble in printing ink and/or a fountain solution within the time required for on-press development is used, (2) the adhesion of an image-recording layer of an unexposed part with a support lowers in the presence of a fountain solution, and (3) an unexposed part is removed by making use of tack of the ink on an inking roller.

### <Observation method of development behavior>

The behavior at the time of on-press development, i.e., whether film removal by falling out is occurring or whether the film is dissolving can be observed and evaluated according to the following method. That is, on-press development is performed by feeding, e.g., "New Champion F-Gloss Medium" (manufactured by Dainippon Ink and Chemicals Inc.) as transparent ink, and a fountain solution on a lithographic printing plate precursor before image exposure, and the component removed by development and transferred to the inking roller is sampled with the ink, and whether the removed product in a solid state that belongs to the category of the film removal by falling out as defined above is present or not is observed with an optical microscope or SEM. When a removed product is present, the size of the product is measured.

### <Evaluating method of the adhesion of an image-recording layer and a support>

The adhesion of an image-recording layer of an unexposed part and a support is an important factor for causing film removal by falling out at the time of on-press development as described above. The adhesion of an image-recording layer and a support can be measured according to the following method.

A printing plate precursor having a size of 50 mm wide × 180 mm long humidity conditioned at 25°C 50 RH % for 1 hour or more is fixed on a movable stage of HEIDON-17 (manufactured by Shinto Scientific Co., Ltd.), and, for example, a polyester adhesive tape No. 3 1 B (manufactured by Nitto Denko Corporation) is adhered in width of 10 mm on the surface of the printing plate precursor. The tip of the adhesive tape is fixed to the axis connected to the sensor part of a load transducer of the maximum detectable load of 200 gf, so that the adhesive tape is peeled by 180° when the movable stage is moved. And then, the movable stage is moved by 150 mm long at a speed of 100 mm/min, and the force at the time when the adhesive tape is peeled from the printing plate precursor is read from the recorder connected to the load transducer. Observing the printing plate precursor after peeling, and in the case where the image-recording layer is removed, the measured value is the adhesion of the image-recording layer and the support per width of 10 mm. While when the image-recording layer is not removed, the measured value means the adhesion of the adhesive tape and outermost surface of the photosensitive material per width of 10 mm, so that the adhesion of the image-recording layer and the support at this time is a value higher than the measured value. This measurement is repeated three times and the average value is taken as the adhesion of the image- recording layer and the support on DRY condition. Further, in the measurement, pure water is dropped on the surface of the printing plate precursor so as to completely cover the part on which the adhesive tape is to be adhered, and 30 seconds after, the adhesive tape is adhered on the surface of the printing plate precursor. The value measured in the same manner, except for the above, as in the measurement of the above adhesion of the image-recording layer and the support on DRY condition is taken as the adhesion of the image-recording layer and the support on WET condition.

Each constitutional component of an image-recording layer that can be used in the lithographic printing plate precursor in the invention will be described below.

### <(A) Infrared absorber>

When the lithographic printing plate precursor of the invention is subjected to image formation with laser emitting infrared rays of from 760 to 1,200 nm as the light source, it is generally essential to use an infrared absorber. Infrared absorbers generally have a function to convert absorbed infrared rays to heat and a function to cause electron transfer/energy transfer to a polymerization initiator described later (a radical generator) by excitation on account of infrared rays. Infrared absorbers fore use in the invention are dyes or pigments having an absorption maximum in the wavelengths of from 760 to 1,200 nm.

As dyes for this purpose, commercially available dyes and known dyes described in literatures, e.g., Senryo Binran (Dye Handbook), compiled by Yuki Gosei Kagaku Kyokai (1970), and the like can be used. Specifically, azo dyes, metal complex salt azo dyes, pyrazolone azo dyes, naphthoquinone dyes, anthraquinone dyes, phthalocyanine dyes, carbonium dyes, quinoneimine dyes, methine dyes, cyanine dyes, squarylium dyestuffs, pyrylium salts and metal thiolate complexes are exemplified. As preferred dyes, e.g., the cyanine dyes disclosed in JP-A-58-125246, JP-A-59-84356 and JP-A-60-78787, the methine dyes disclosed in JP-A-58-173696, JP-A-58-181690 and JP-A-58-194595, the naphthoquinone dyes disclosed in JP-A-58-112793, JP-A-58-224793, JP-A-59-48187, JP-A-59-73996, JP-A-60-52940 and JP-A-60-63744, the squarylium dyestuffs disclosed in JP-A-58-112792, and the cyanine dyes disclosed in British Patent 434,875 are exemplified.

Further, the near infrared absorbing sensitizers disclosed in U.S. Patent 5,156,938 are also preferably used, in addition, the substituted arylbenzo(thio)pyrylium salts disclosed in U.S. Patent 3,881,924, the trimethine thiapyrylium salts disclosed in JP-A-57-142645 (corresponding to U.S. Patent 4,327,169), the pyrylium compounds disclosed in JP-A-58-181051, JP-A-58-220143, JP-A-59-41363, JP-A-59-84248, JP-A-59-84249, JP-A-59-146063 and JP-A-59-146061, the cyanine dyestuffs disclosed in JP-A-59-216146, the pentamethine thiopyrylium salts disclosed in U.S. Patent 4,283,475, and the pyrylium compounds disclosed in JP-B-5-13514 (the term "JP-B" as used herein refers to an "examined Japanese patent publication") and JP-B-5-19702 are also preferably used in the present invention. As other examples of preferred dyes, the near infrared absorbing dyes disclosed in U.S. Patent 4,756,993 as the compounds represented by formulae (I) and (II) can be exemplified. As other preferred examples of infrared absorbers for use in the invention, the specific indolenine cyanine dyestuffs disclosed in JP-A-2002-278057 as shown below are exemplified.

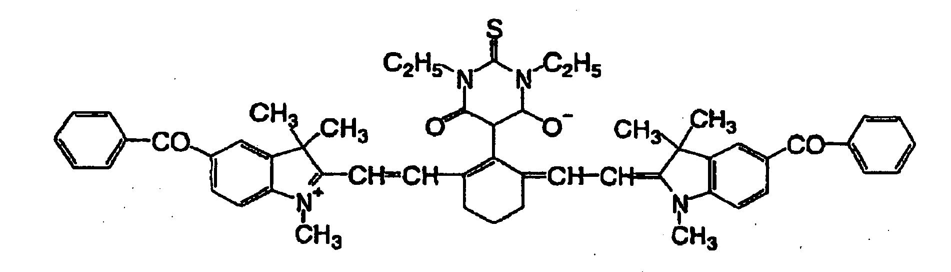

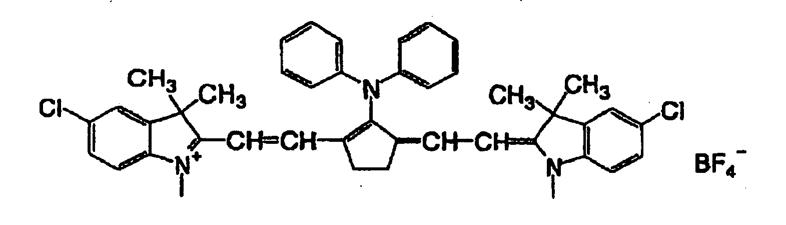

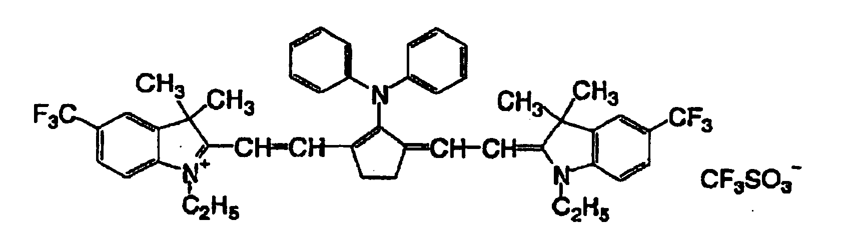

Of the above dyes, cyanine dyestuffs, squarylium dyestuffs, pyrylium salts, nickel thiolate complexes and indolenine cyanine dyestuffs are especially preferred. Cyanine dyestuffs and indolenine cyanine dyestuffs are more preferred, and a cyanine dyestuff represented by the following formula (i) is an especially preferred example.
Formula (i)

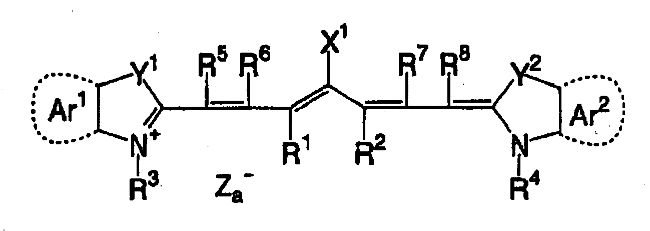

In formula (i), X¹ represents a hydrogen atom, a halogen atom, -NPh₂ (Ph represents a phenyl group), X² -L¹, or the following shown group; X² represents an oxygen atom, a nitrogen atom or a sulfur atom; and L¹ represents a hydrocarbon group having from 1 to 12 carbon atoms, an aromatic ring having a hetero atom, or a hydrocarbon group containing a hetero atom and having from 1 to 12 carbon atoms. The hetero atom here represents N, S, O, a halogen atom or Se. Xₐ⁻ is defined as the same with the later-described Zₐ⁻, and R^{a} represents a substituent selected from a hydrogen atom, an alkyl group, an aryl group, a substituted or unsubstituted amino group, and a halogen atom.

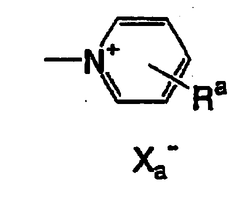

R¹ and R² each independently represents a hydrocarbon group having from 1 to 12 carbon atoms. In view of the preservation stability of a recording layer coating solution, R¹ and R² each preferably represents a hydrocarbon group having 2 or more carbon atoms, and particularly preferably R¹ and R² are bonded to each other to form a 5- or 6-membered ring.

Ar¹ and Ar², which may be the same or different, each represents an aromatic hydrocarbon group that may have a substituent. The examples of preferred aromatic hydrocarbon groups include a benzene ring and a naphthalene ring. The preferred examples of the substituents include a hydrocarbon group having 12 or less carbon atoms, a halogen atom, and an alkoxyl group having 12 or less carbon atoms. Y' and Y², which may be the same or different, each represents a sulfur atom or a dialkylmethylene group having 12 or less carbon atoms. R³ and R⁴, which may be the same or different, each represents a hydrocarbon group having 20 or less carbon atoms that may have a substituent. The preferred examples of the substituents include an alkoxyl group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms, preferably a hydrogen atom because of easy availability of the material. Zₐ⁻ represents a counter anion, provided that when a cyanine dyestuff represented by formula (i) has an anionic substituent within the structure and the neutralization of the electric charge is not necessary, Zₐ⁻ is not necessary. Zₐ⁻ preferably represents a halogen ion, a perchlorate ion, a tetrafluoroborate ion, a hexafluorophosphate ion or a sulfonate ion in view of the preservation stability of a recording layer coating solution, and especially preferably, a perchlorate ion, a hexafluorophosphate ion or an arylsulfonate ion.

As the specific examples of cyanine dyestuffs represented by formula (i) that can be preferably used in the invention, those disclosed in JP-A-2001-133969, paragraphs [0017] to [0019] can be exemplified. Further, as especially preferred other examples, the specific indolenine cyanine dyestuffs disclosed in JP-A-2002-278057 are exemplified.

As the pigments used in the invention, commercially available pigments and the pigments described in Color Index (C.I.) Binran (Color Index Bulletin), Shaishin Ganryo Binran (The Latest Pigment Handbook), compiled by Nippon Ganryo Gijutsu Kyokai (1977), Shaishin Ganryo Oyo Gijutsu (The Latest Pigment Applied Techniques), CMC Publishing Co. Ltd. (1986), and Insatsu Ink Gijutsu (Printing Ink Techniques), CMC Publishing Co. Ltd. (1984) can be used.

As the kinds of pigments, e.g., black pigments, yellow pigments, orange pigments, brown pigments, red pigments, purple pigments, blue pigments, green pigments, fluorescent pigments, metallic powder pigments, and polymer-bond pigments can be exemplified. Specifically, insoluble azo pigments, azo lake pigments, condensation azo pigments, chelate azo pigments, phthalocyanine pigments, anthraquinone pigments, perylene and perinone pigments, thioindigo pigments, quinacridone pigments, dioxazine pigments, isoindolinone pigments, quinophthalone pigments, dyed lake pigments, azine pigments, nitroso pigments, nitro pigments, natural pigments, fluorescent pigments, inorganic pigments, and carbon black can be used. Of these pigments, carbon black is preferably used.

These pigments can be used without surface treatment or may be surface-treated. As the methods of surface treatments, a method of coating the surfaces of pigments with resins and waxes, a method of adhering surfactants, and a method of bonding reactive substances (e.g., silane coupling agents, epoxy compounds, or polyisocyanate) on the surfaces of pigments can be exemplified. These surface treatment methods are described in Kinzoku Sekken no Seishitsu to Oyo (The Natures and Applications of Metal Soaps), Saiwai Shobo Co., Ltd., Insatsu Ink Gijutsu (Printing Ink Techniques), CMC Publishing Co., Ltd. (1984), and Shaishin Ganryo Oyo Gijutsu (The Latest Pigment Applied Techniques), CMC Publishing Co., Ltd. (1986).

The particle size of pigments is preferably from 0.01 to 10 µm, more preferably from 0.05 to 1 µm, and especially preferably from 0.1 to 1 µm. When the particle size of pigments is in this range, good stability of pigment dispersion in an image-recording layer coating solution and good uniformity of an image-recording layer can be obtained.

Well-know dispersing techniques used in the manufacture of inks and toners can be used as the dispersing methods of pigments. The examples of dispersing apparatus include an ultrasonic wave disperser, a sand mill, an attritor, a pearl mill, a super-mill, a ball mill, an impeller, a disperser, a KD mill, a colloid mill, a dynatron, a three-roll mill and a pressure kneader, and details are described in Shaishin Ganryo Oyo Gijutsu (The Latest Pigment Applied Techniques), CMC Publishing Co., Ltd. (1986).

These infrared absorbers may be added to the same layer with other components, or a different layer may be provided and added thereto. However, when a negative lithographic printing plate precursor is prepared, infrared absorbers are added so that the absorbance of the image-recording layer at the maximum absorption wavelength in the range of wavelengths of from 760 to 1,200 nm is from 0.3 to 1.2 by reflection measuring method, and preferably from 0.4 to 1.1. In this range of the addition amount of infrared absorbers, the polymerization reaction proceeds uniformly in the depth direction of the image-recording layer and good layer strength of the image part and the adhesion to the support can be obtained.

The absorbance of an image-recording layer can be adjusted by the amount of an infrared absorber added to the image-recording layer and the thickness of the image-recording layer. Absorbance can be measured by ordinary methods, e.g., a method of forming an image-recording layer having a thickness arbitrarily determined in a dry coating weight necessary as the lithographic printing plate on a reflective support, e.g., an aluminum support, and measuring the reflection density with an optical densitometer, and a method of measuring the absorbance by a reflection method with a spectrophotometer using an integrating sphere are exemplified.

### <(B) Polymerization initiator>

Polymerization initiators for use in the invention are compounds capable of generating a radical by light or heat, or both energies, and initiating and accelerating the polymerization of compounds having a polymerizable unsaturated group. As the polymerization generators that can be used in the invention, known thermal polymerization initiators, compounds having a bond small in association- dissociation energy, and photopolymerization initiators can be used, and the compounds generating a radical preferably used in the invention are compounds capable of generating a radical by heat energy and initiating and accelerating the polymerization of compounds having a polymerizable unsaturated group. As the thermal radical generators for use in the invention, known polymerization initiators and compounds having a bond small in association-dissociation energy can be arbitrarily selected and used. The compounds generating a radical can be used alone, or two or more kinds may be used in combination. As the compounds generating a radical, e.g., organic halogen compounds, carbonyl compounds, organic peroxide compounds, azo-based polymerization initiators, azide compounds, metallocene compounds, hexaarylbiimidazole compounds, organic boric acid compounds, disulfonic acid compounds, oxime ester compounds, and onium salt compounds are exemplified.

As the organic halogen compounds, specifically, the compounds described in Wakabayashi et al., Bull. Chem. Soc. Japan, 42, 2924 (1969), U.S. Patent 3,905,815, JP-B-46-4605, JP-A-48-36281, JP-A-55-32070, JP-A-60-239736, JP-A-61-169835, JP-A-61-169837, JP-A-62-58241, JP-A-62-212401, JP-A-63-70243, JP-A-63-298339, and M.P. Hutt, Journal of Heterocyclic Chemistry, 1 (No. 3) (1970) are exemplified. Of these compounds, oxazole compounds substituted with a trihalomethyl group and S-triazine compounds are preferably used.

More preferably, s-triazine derivatives in which at least one mono-, di- or tri-halogen-substituted methyl group is bonded to the s-triazine ring, and oxadiazole derivatives in which at least one mono-, di- or tri-halogen-substituted methyl group is bonded to the oxadiazole ring are exemplified. Specifically, 2,4,6-tris(monochloromethyl)-s-triazine, 2,4,6-tris(dichloromethyl)-s-triazine, 2,4,6-tris-(trichloromethyl)-s-triazine, 2-methyl-4,6-bis(trichloro-methyl)-s-triazine, 2-n-propyl-4,6-bis(trichloromethyl)-s-triazine, 2-(α,α,β-trichloroethyl)-4,6-bis(trichloro-methyl)-s-triazine, 2-phenyl-4,6-bis(trichloromethyl)-s-triazine, 2-(p-methoxyphenyl)-4,6-bis(trichloromethyl)-s-triazine, 2-(3,4-epoxyphenyl)-4,6-bis(trichloromethyl)-s-triazine, 2-(p-chlorophenyl)-4,6-bis(trichloromethyl)-s-triazine, 2-[1-(p-methoxyphenyl)-2,4-butadienyl]-4,6-bis-(trichloromethyl)-s-triazine, 2-styryl-4,6-bis(trichloro-methyl)-s-triazine, 2-(p-methoxystyryl)-4,6-bis(trichloro-methyl)-s-triazine, 2-(p-i-propyloxystyryl)-4,6-bis-(trichloromethyl)-s-triazine, 2-(p-tolyl)-4,6-bis-(trichloromethyl)-s-triazine, 2-(4-nathoxynaphthyl)-4,6-bis(trichloromethyl)-s-triazine, 2-phenylthio-4,6-bis-(trichloromethyl)-s-triazine, 2-benzylthio-4,6-bis-(trichloromethyl)-s-triazine, 2,4,6-tris(dibromomethyl)-s-triazine, 2,4,6-tris(tribromomethyl)-s-triazine, 2-methyl-4,6-bis(tribromomethyl)-s-triazine, 2-methoxy-4,6-bis(tribromomethyl)-s-triazine, and the following compounds are exemplified.

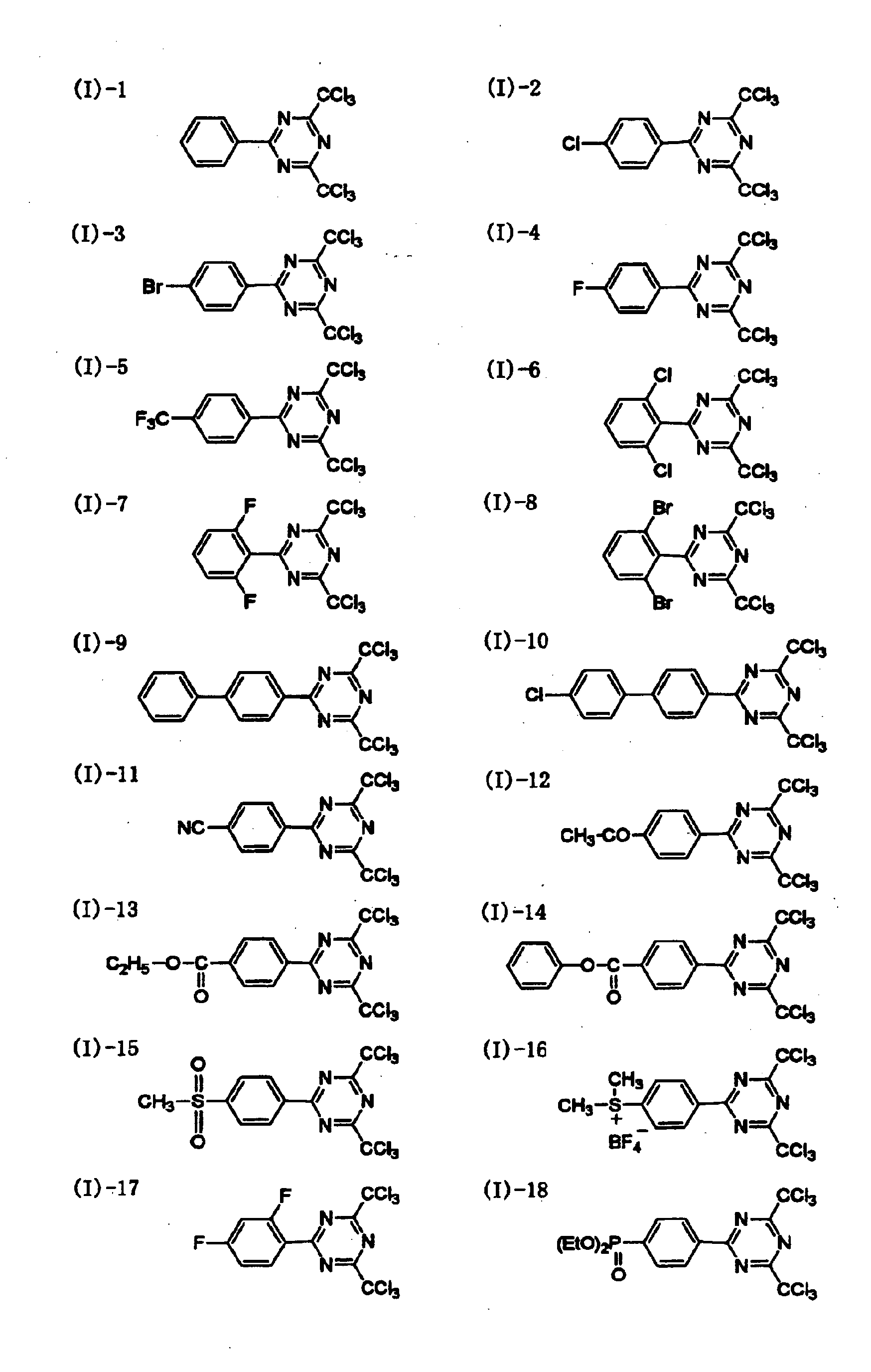

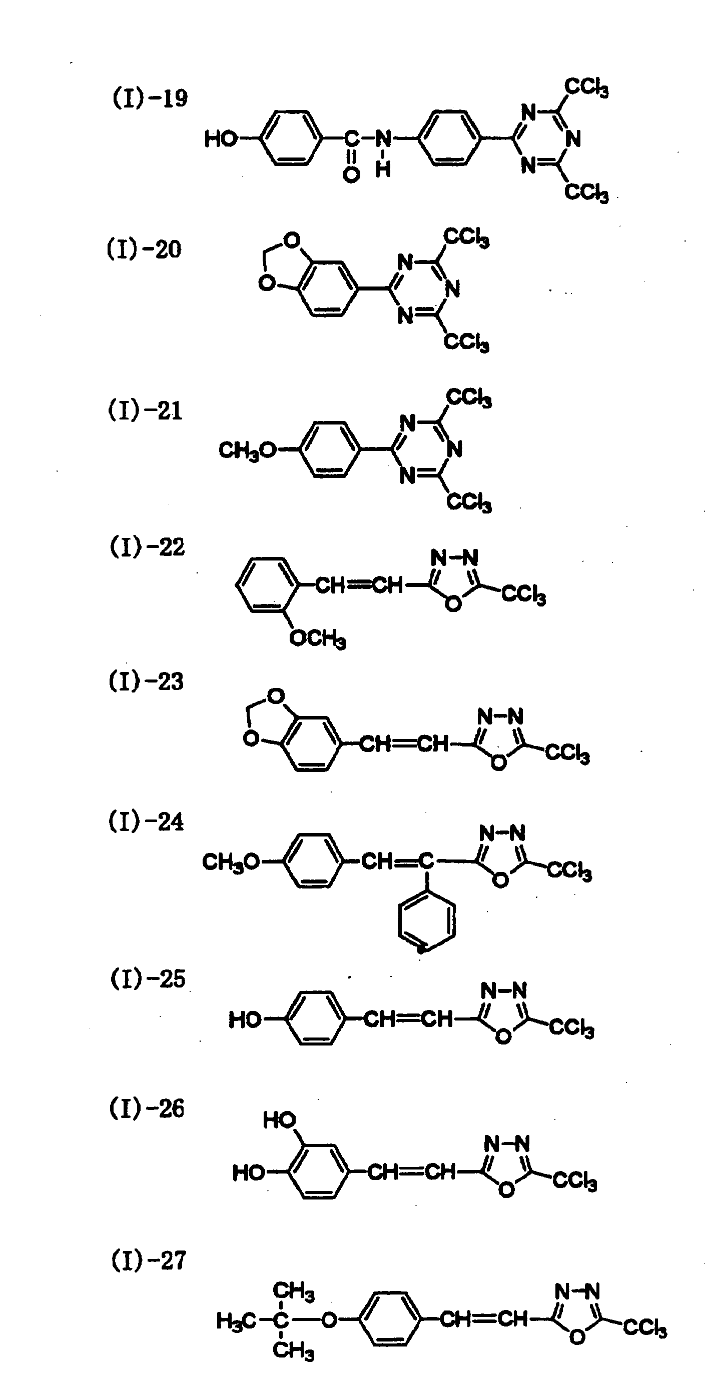

As the carbonyl compounds, benzophenone derivatives, e.g., benzophenone, Michler's ketone, 2-methylbenzophenone, 3-methylbenzophenone, 4-methylbenzophenone, 2-chlorobenzo-phenone, 4-bromobenzophenone, 2-carboxybenzophenone, etc., acetophenone derivatives, e.g., 2,2-dimethoxy-2-phenyl-acetophenone, 2,2-diethoxyacetophenone, 1-hydroxycyclohexyl phenyl ketone, α-hydroxy-2-methylphenylpropanone, 1-hydroxy-1-methylethyl-(p-isopropylphenyl) ketone, 1-hydroxy-1-(p-dodecylphenyl) ketone, 2-methyl-(4'-(methylthio)phenyl)-2-morpholino-1-propanone, 1,1,1-trichloromethyl-(p-butyl- phenyl) ketone, etc., thioxanthone derivatives, e.g., thioxanthone, 2-ethylthioxanthone, 2-isopropylthioxanthone, 2-chlorothioxanthone, 2,4-dimethylthioxanthone, 2,4-diethylthioxanthone, 2,4-diisopropylthioxanthone, etc., and benzoate derivatives, e.g., ethyl p-dimethylaminobenzoate, ethyl p-diethylaminobenzoate, etc., are exemplified.

As the azo compounds, e.g., the azo compounds disclosed in JP-A-8-108621, etc., can be used.

As the organic peroxide compounds, e.g., trimethyl- cyclohexanone peroxide, acetylacetone peroxide, 1,1-bis-(tert-butylperoxy)-3,3,5-trimethylcyclohexane, 1,1-bis-(tert-butylperoxy)cyclohexane, 2,2-bis(tert-butylperoxy)-butane, tert-butyl hydroperoxide, cumene hydroperoxide, diisopropylbenzene hydroperoxide, 2,5-dimethylhexane-2,5-dihydroperoxide, 1,1,3,3-tetramethylbutyl hydroperoxide, tert-butyleumyl peroxide, dicumyl peroxide, 2,5-dimethyl-2,5-di(tert-butylperoxy)hexane, 2,5-oxanoyl peroxide, succinic acid peroxide, benzoyl peroxide, 2,4-dichlorobenzoyl peroxide, diisopropylperoxy dicarbonate, di-2-ethylhexyl-peroxy dicarbonate, di-2-ethoxyethylperoxy dicarbonate, dimethoxyisopropylperoxy carbonate, di(3-methyl-3-methoxy-butyl)peroxy dicarbonate, tert-butylperoxy acetate, tert-butylperoxy pivalate, tert-butylperoxy neodecanoate, tert-butylperoxy octanoate, tert-butylperoxy laurate, tertiary carbonate, 3,3',4,4'-tetra(t-butylperoxycarbonyl)benzo-phenone, 3,3',4,4'-tetra(t-hexylperoxycarbonyl)benzo-phenone, 3,3' ,4,4' -tetra(p-isopropylcumylperoxycarbonyl)-benzophenone, carbonyldi(t-butylperoxydihydrogen-diphthalate), carbonyldi(t-hexylperoxydihydrogen-diphthalate), etc., are exemplified.

As the metallocene compounds, various titanocene compounds disclosed in JP-A-59-152396, JP-A-61-151197, JP-A-63-41484, JP-A-2-249, JP-A-2-4705 and JP-A-5-83588, e.g., dicyclopentadienyl-Ti-bis-phenyl, dicyclopentadienyl-Ti-bis-2,6-difluorophen-1-yl, dicylopentadienyl-Ti-bis-2,4-difluorophen-1-yl, dicyclopentadienyl-Ti-bis-2,4,6-trifluorophen-1-yl, dicyclopentadienyl-Ti-bis-2,3,5,6-tetrafluorophen-1-yl, dicyclopentadienyl-Ti-bis-2,3,4,5,6-pentafluorophen-1-yl, dimethylcyclopentadienyl-Ti-bis-2,6-difluorophen-1-yl, dimethylcyclopentadienyl-Ti-bis-2,4,6-trifluorophen-1-yl, dimethylcylopentadienyl-Ti-bis-2,3,5,6-tetrafluorophen-1-yl, dimethylcyclopentadienyl-Ti-bis-2,3,4,5,6-pentafluorophen-1-yl, and the iron-allene complexes disclosed in JP-A-1-304453 and JP-A-1-152109 are exemplified.

As the hexaarylbiimidazole compounds, various compounds disclosed in JP-B-6-29285, U.S. Patents 3,479,185, 4,311,783 and 4,622,286, specifically, e.g., 2,2'-bis(o-chlorophenyl)-4,4',5,5'-tetraphenylbiimidazole, 2,2'-bis(o-bromophenyl)) 4,4',5,5'-tetraphenylbiimidazole, 2,2'-bis(o,p-dichloro-phenyl)-4,4',5,5'-tetraphenylbiimidazole, 2,2'-bis-(o-chlorophenyl)-4,4',5,5'-tetra(m-methoxyphenyl)biijidazole, 2,2'-bis(o,o'-dichlorophenyl)-4,4',5,5'-tetraphenyl-biimidazole, 2,2'-bis(o-nitrophenyl)-4,4',5,5'-tetraphenyl-biimidazole, 2,2'-bis(o-methylphenyl)-4,4',5,5'-tetra-phenylbiimidazole, 2,2'-bis(o-trifluorophenyl)-4,4',5,5'- tetraphenylbiimidazole, etc., are exemplified.

As the organic borate compounds, e.g., the organic borates disclosed in JP-A-62-143044, JP-A-62-150242, JP-A-9-188685, JP-A-9-188686, JP-A-9-188710, JP-A-2000- 131837, JP-A-2002-107916, Japanese Patent No. 2764769, JP-A-2002-116539, and Kunz, Martin, "Rad Tech '98 Proceeding April 19-22, 1998, Chicago", etc., the organic boron sulfonium complexes or the organic boron oxosulfonium complexes disclosed in JP-A-6-157623, JP-A-6-175564 and JP-A-6-175561, the organic boron iodonium complexes disclosed in JP-A-6-175554 and JP-A-6-175553, the organic boron phosphonium complexes disclosed in JP-A-9-188710, and the organic boron transition metal coordination complexes disclosed in JP-A-6-348011, JP-A-7-128785, JP-A-7-140589, JP-A-7-306527 and JP-A-7-292014, etc., are exemplified.

As the disulfone compounds, the compounds disclosed in JP-A-61-166544, JP-A-2002-328465, etc., are exemplified.

As the oxime ester compounds, the compounds described in J.C.S. Perkin II, (1979) 1653-1660), J.C.S. Perkin II, (1979) 156-162, Journal of Photopolymer Science and Technology, pp. 202-232 (1995), and JP-A-2000-66385, and the compounds disclosed in JP-A-2000-80068, and specifically the compounds represented by the following formulae are exemplified.

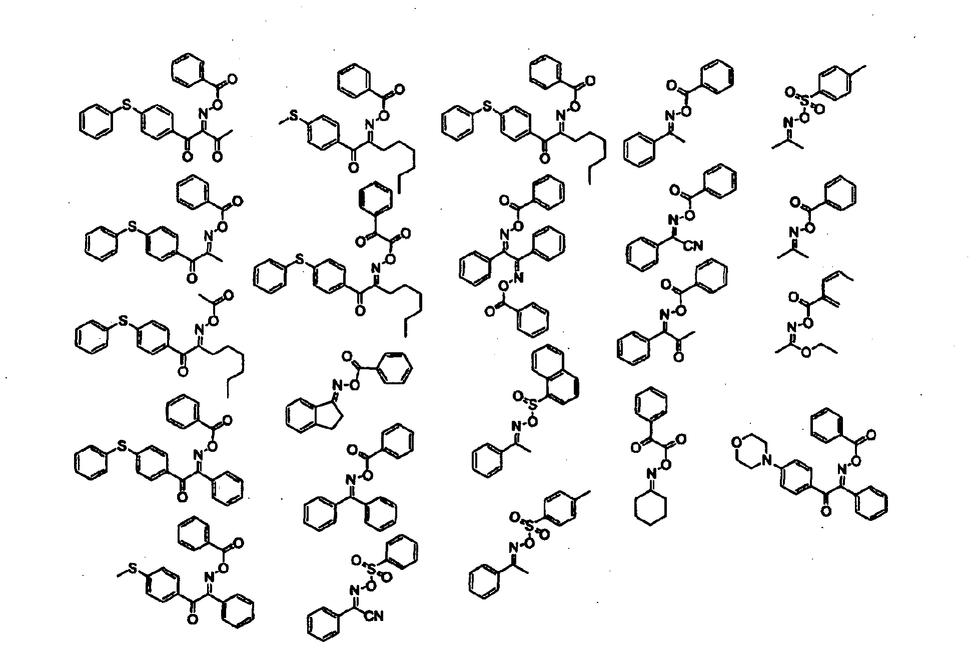

As the onium salt compounds, onium salts, e.g., the diazonium salts described in S.I. Schlesinger, Photogr. Sci. Eng., 18, 387 (1974), and T.S. Bal et al., Polymer, 21, 423 (1980), the ammonium salts disclosed in U.S. Patent 4,069,055 and JP-A-4-365049, the phosphonium salts disclosed in U.S. Patents 4,069,055 and 4,069,056, the iodonium salts disclosed in EP 104,143, U.S. Patents 339,049, 410,201, JP-A-2-150848 and JP-A-2-296514, the sulfonium salts disclosed in EP 370,693, EP 390,214, EP 233,567, EP 297,443, EP 297,442, U.S. Patents 4,933,377, 161,811, 410,201, 339,049, 4,760,013, 4,734,444, 2,833,827, German Patents. 2,904,626, 3,604,580 and 3,604,581, the selenonium salts described in J.V. Crivello et al., Macromolecules, 10 (6), 1307 (1977), and J.V. Crivello et al., J. Polymer Sci., Polymer Chem. Ed., 17, 1047 (1979), the arsonium salts described in C.S. Wen et al., Teh. Proc. Conf. Rad. Curing ASIA, p. 478, Tokyo, Oct (1988), etc., are exemplified.

Especially from the aspects of reactivity and stability, the above oxime ester compounds, or the diazonium salts, iodonium salts and sulfonium salts are exemplified. In the invention, these onium salts function as ionic radical polymerization initiators not acid generators. The onium salts preferably used in the invention are the onium salts represented by the following formulae (RI-I) to (RI-III).

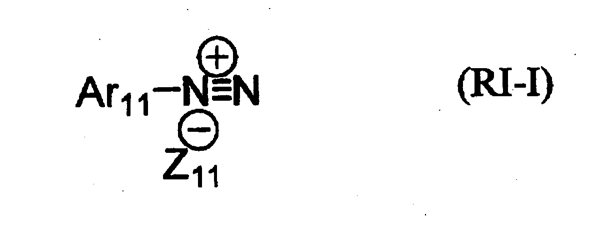

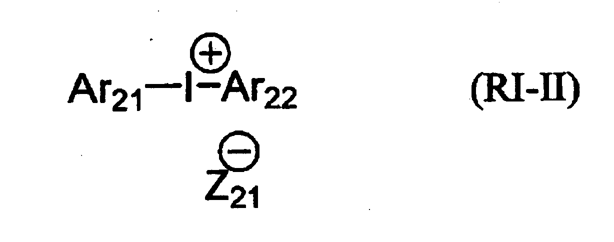

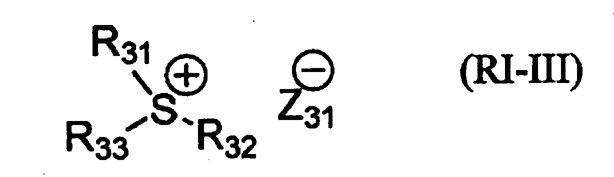

In formula (RI-I), Ar₁₁ represents an aryl group having 20 or less carbon atoms, which may have from 1 to 6 substituents, and as the preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₁₁⁻ represents a univalent anion, and preferably a halogen ion, a perchlorate ion, a hexafluorophosphate ion, a tetrafluoroborate ion, a sulfonate ion, a sulfinate ion, a thiosulfonate ion, and a sulfate ion are exemplified. In view of stability, a perchlorate ion, a hexafluorophosphate ion, a tetrafluoroborate ion, a sulfonate ion and a sulfinate ion are preferred.

In formula (RI-II), Ar₂₁ and Ar₂₂ each independently represents an aryl group having 20 or less carbon atoms, which may have from 1 to 6 substituents, and as the preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkyl- amino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₂₁⁻ represents a univalent anion, e.g., a halogen ion, a perchlorate ion, a hexafluorophosphate ion, a tetrafluoro- borate ion, a sulfonate ion, a sulfinate ion, a thiosulfonate ion, a sulfate ion, and a carboxylate ion are exemplified. In view of stability and reactivity, a perchlorate ion, a hexafluorophosphate ion, a tetrafluoroborate ion, a sulfonate ion, a sulfinate ion, and a carboxylate ion are preferred.

In formula (RI-III), R₃₁, R₃₂ and R₃₃ each independently represents an aryl, alkyl, alkenyl or alkynyl group having 20 or less carbon atoms, which may have from 1 to 6 substituents. In the light of reactivity and stability, an aryl group is preferred. As the preferred substituents, an alkyl group having from 1 to 12 carbon atoms, an alkenyl group having from 1 to 12 carbon atoms, an alkynyl group having from 1 to 12 carbon atoms, an aryl group having from 1 to 12 carbon atoms, an alkoxyl group having from 1 to 12 carbon atoms, an aryloxy group having from 1 to 12 carbon atoms, a halogen atom, an alkylamino group having from 1 to 12 carbon atoms, a dialkylamino group having from 1 to 12 carbon atoms, an alkylamido or arylamido group having from 1 to 12 carbon atoms, a carbonyl group, a carboxyl group, a cyano group, a sulfonyl group, a thioalkyl group having from 1 to 12 carbon atoms, and a thioaryl group having from 1 to 12 carbon atoms are exemplified. Z₃₁⁻ represents a univalent anion, e.g., a halogen ion, a perchlorate ion, a hexafluorophosphate ion, a tetrafluoroborate ion, a sulfonate ion, a sulfinate ion, a thiosulfonate ion, a sulfate ion, and a carboxylate ion are exemplified, and from the aspects of stability and reactivity, a perchlorate ion, a hexafluoro- phosphate ion, a tetrafluoroborate ion, a sulfonate ion, a sulfinate ion, and a carboxylate ion are preferred. The carboxylate ion disclosed in JP-A-2001-343742 is more preferred, and the carboxylate ion disclosed in JP-A-2002- 148790 is especially preferred.

The specific examples of polymerization initiators applicable to the invention are shown below, but the invention is not restricted thereto.

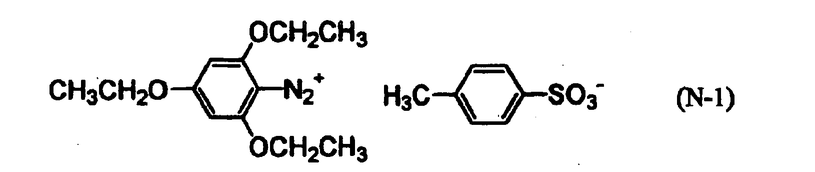

PF₆⁻ (N-2)

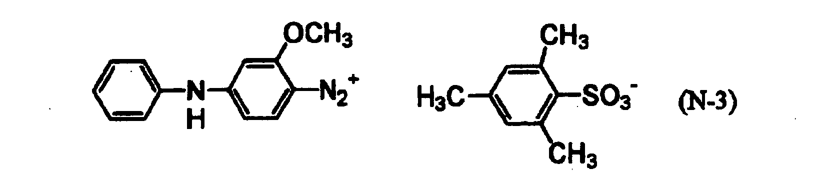

ClO₄⁻ (N-4)

PF₆⁻ (N-5)

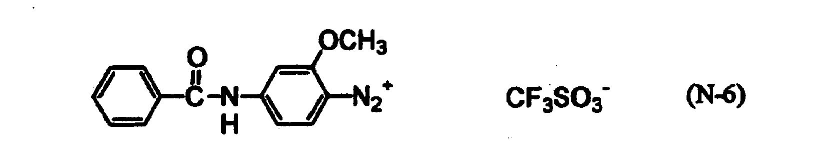

BF₄⁻ (N-7)

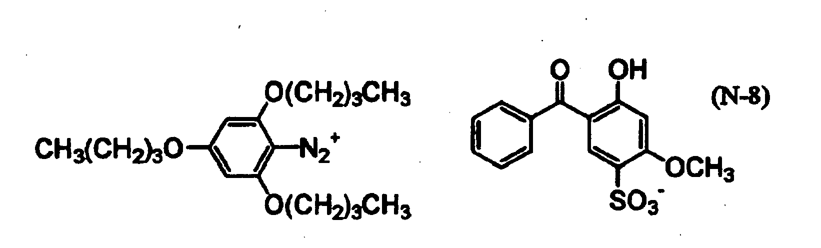

CIO₄⁻ (N-9)

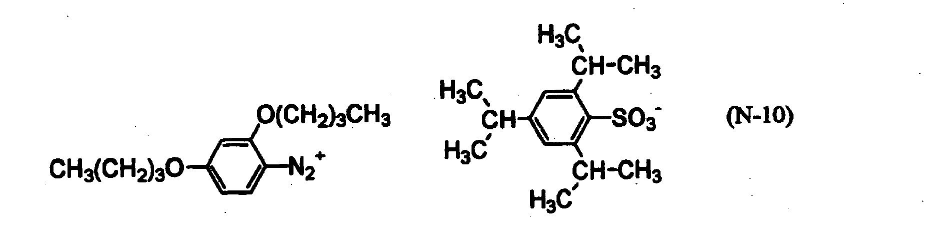

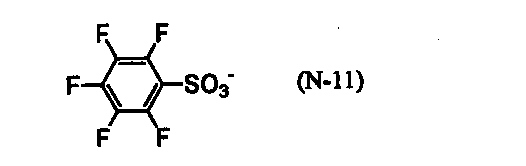

PF₆⁻ (N-12)

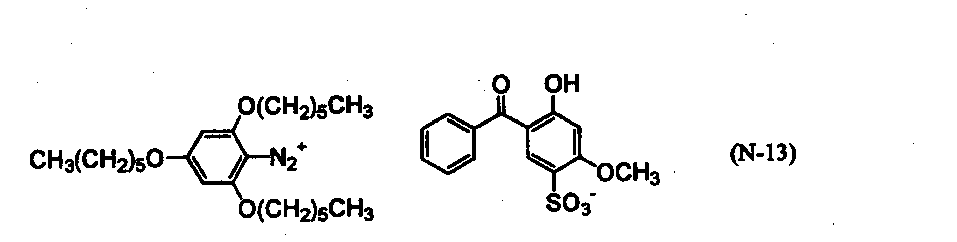

ClO₄⁻ (N-14)

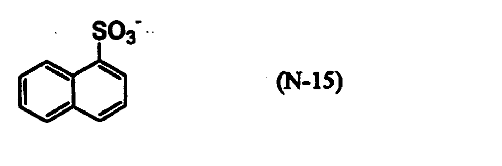

PF₆⁻ (N-16)

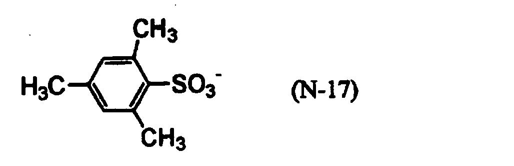

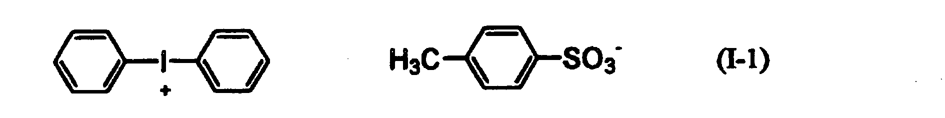

PF₆⁻ (I-2)

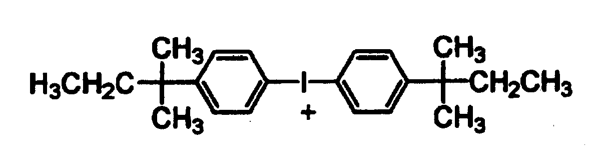

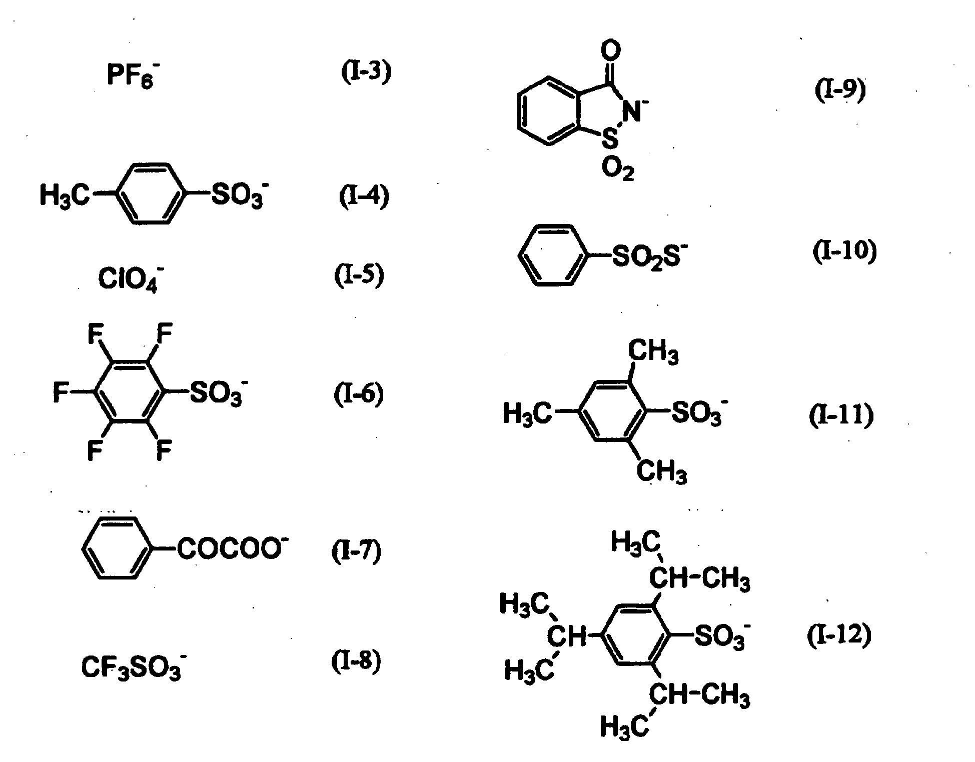

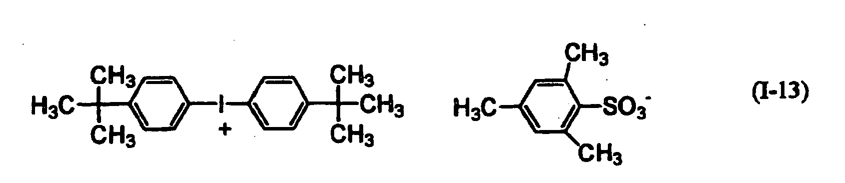

ClO₄⁻ (I-14)

PF₆⁻ (I-15)

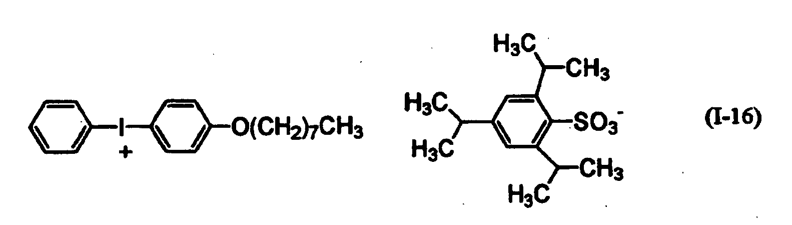

CF₃COO⁻ (I-17)

CF₃SO₃ (I-18)

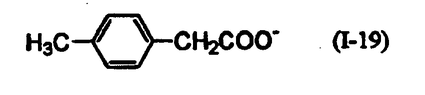

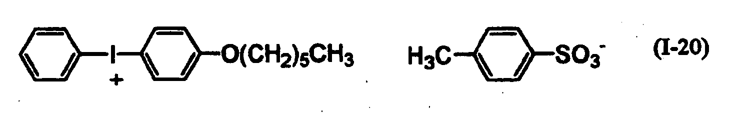

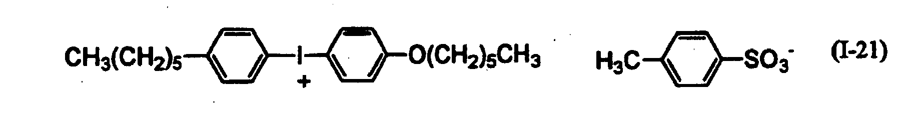

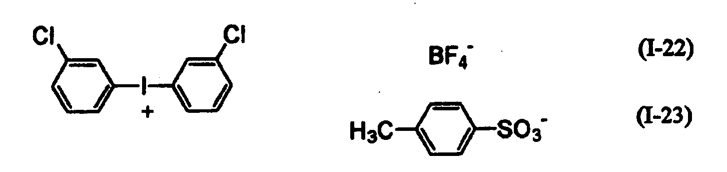

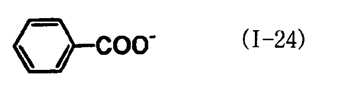

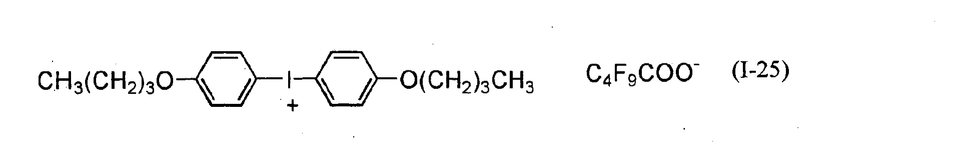

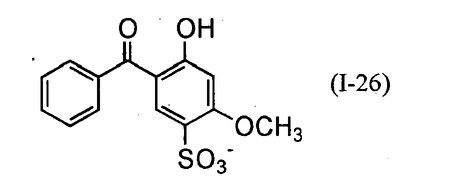

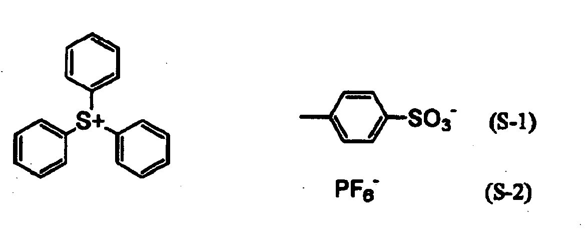

ClO₄⁻ (S-3)

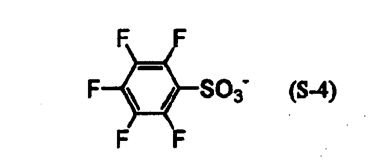

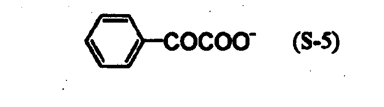

CF₃SO₃⁻ (S-6)

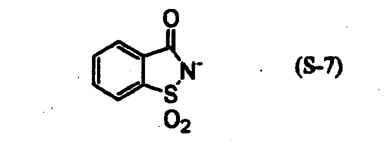

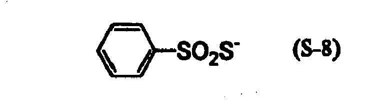

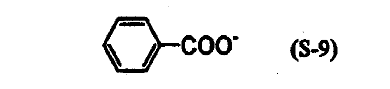

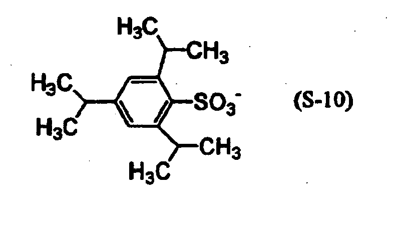

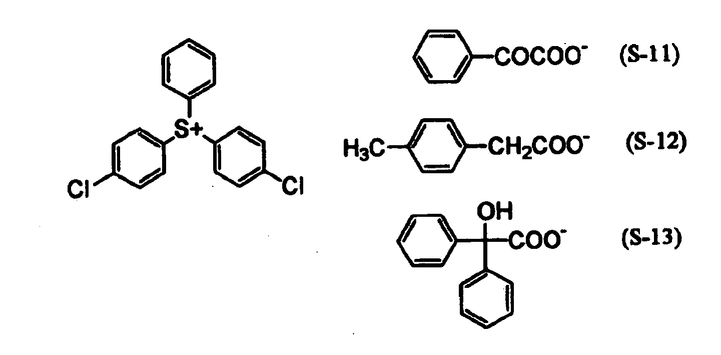

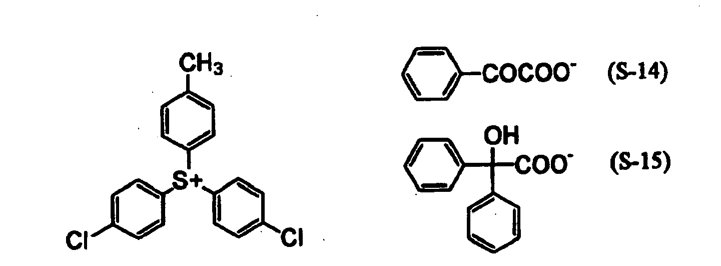

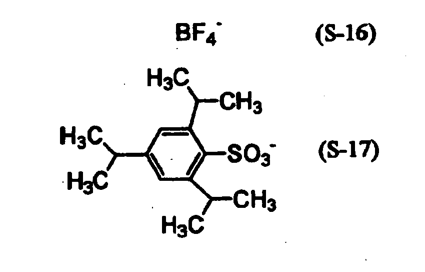

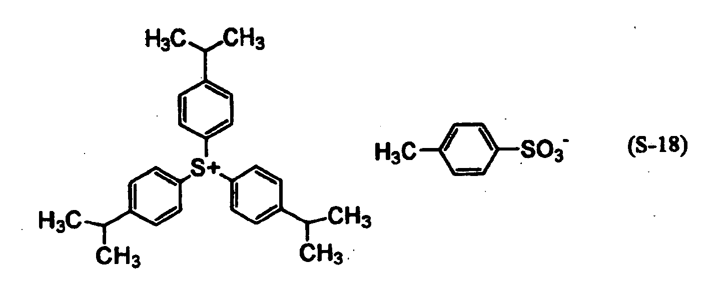

Polymerization initiators are not restricted to the above compounds, but from the aspects of reactivity and stability, a triazine-based initiator, an organic halogen compound, an oxime ester compound, a diazonium salt, an iodonium salt, and a sulfonium salt are more preferred.

In the image-recording layer of a lithographic printing plate precursor that is imagewise exposed with light sources of emitting rays of from 250 to 420 nm, by using a sensitizer in combination with a polymerization initiator selected from the above exemplified compounds, radical generating efficiency can also be enhanced.

The specific examples of sensitizers include benzoin, benzoin methyl ether, benzoin ethyl ether, 9-fluorenone, 2-chloro-9-fluorenone, 2-methyl-9-fluorenone, 9-anthrone, 2-bromo-9-anthrone, 2-ethyl-9-anthrone, 9,10-anthraquinone, 2-ethyl-9,10-anthraquinone, 2-t-butyl-9,10-anthraquinone, 2,6-dichloro-9,10-anthraquinone, xanthone, 2-methylxanthone, 2-methoxyxanthone, thioxanthone, benzyl, dibenzalacetone, p-(dimethylamino)phenyl styryl ketone, p-(dimethylamino)- phenyl p-methyl styryl ketone, benzophenone, p-(dimethyl- amino)benzophenone (or Michler's ketone), p-(diethylamino)-benzophenone, benzanthrone, etc.

Further, as a sensitizer preferably used in the invention, a compound represented by the following formula (II) disclosed in JP-B-51-48516 is exemplified.

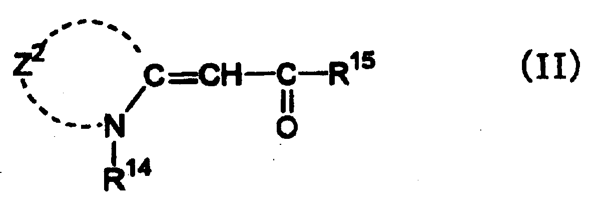

In formula (II), R¹⁴ represents an alkyl group (e.g., a methyl group, an ethyl group, a propyl group, etc.), or a substituted alkyl group (e.g., a 2-hydroxyethyl group, a 2-methoxyethyl group, a carboxymethyl group, a 2-carboxyethyl group, etc.); R¹⁵ represents an alkyl group (e.g., a methyl group, an ethyl group, etc.), or an aryl group (e.g., a phenyl group, a p-hydroxyphenyl group, a naphthyl group, a thienyl group, etc.).

Z² represents a nonmetallic atomic group necessary to form a nitrogen-containing heterocyclic nucleus generally used in cyanine dyestuffs, such as benzothiazoles (benzothiazole, 5-chlorobenzothiazole, 6-chlorobenzo- thiazole, etc.), naphthothiazoles (α-naphthothiazole, β-naphthothiazole, etc.), benzoselenazoles (benzoselenazole, 5-chlorobenzoselenazole, 6-methoxybenzoselenazole, etc.), naphthoselenazoles (α-naphthoselenazole, β-naphtho- selenazole, etc.), benzoxazoles (benzoxazole, 5-methylbenz- oxazole, 5-phenylbenzoxazole, etc.), and naphthoxazoles (α-naphthoxazole, β-naphthoxazole, etc.).

The specific examples of the compounds represented by formula (II) have chemical structures in which Z², R¹⁴ and R¹⁵ are combined, and many compounds are present as well-known compounds. Accordingly, the compounds represented by formula (II) can be arbitrarily selected from well-known compounds. Further, as preferred sensitizers in the invention, the merocyanine dyestuffs disclosed in JP-B-5-47095 and the ketocoumarin-based compounds represented by the following formula (III) can also be exemplified.

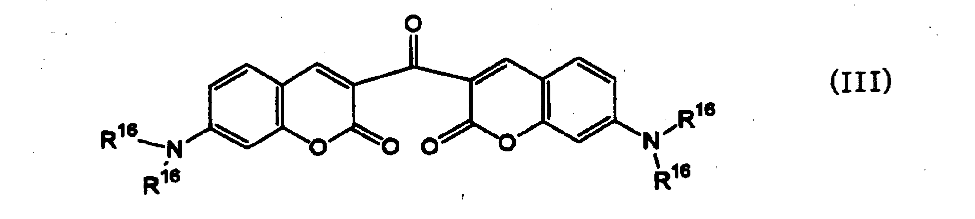

In formula (III), R¹⁶ represents an alkyl group, e.g., a methyl group, an ethyl group, etc.

These polymerization initiators and sensitizers can be preferably used in an amount of from 0.1 to 50 mass% based on all the solids content constituting the image-recording layer, more preferably from 0.5 to 30 mass%, and still more preferably from 0.8 to 20 mass%. When they are used within this range, good sensitivity and good resistance to staining of the non-image part in printing can be obtained. These polymerization initiators may be used alone, or two or more kinds may be used in combination. These polymerization initiators may be used with other components in the same layer, or other layer may be provided to contain the polymerization initiators.

### <(C) Polymerizable compound>

The polymerizable compounds that can be used in the invention are addition polymerizable compounds having at least one ethylenic unsaturated double bond, and they are selected from the compounds having at least one, preferably two or more, terminal ethylenic unsaturated bonds. These compounds are well known in the field of this industry, and they can be used with no particular restriction in the invention. These polymerizable compounds have chemical forms of, e.g., a monomer, a prepolymer, i.e., a dimer, a trimer, an oligomer, or a mixture and a copolymer of them. As the examples of the monomers and the copolymers thereof, unsaturated carboxylic acids (e.g., acrylic acid, methacrylic acid, itaconic acid, crotonic acid, isocrotonic acid, maleic acid, etc.), and esters and amides of these unsaturated carboxylic acids are exemplified, and preferably esters of unsaturated carboxylic acids and aliphatic polyhydric alcohol compounds, and amides of unsaturated carboxylic acids and aliphatic polyhydric amine compounds are used. Further, the addition reaction products of esters and amides of unsaturated carboxylic acids having a nucleophilic substituent such as a hydroxyl group, an amino group or a mercapto group with monofunctional or polyfunctional isocyanates or epoxies, and the dehydration condensation reaction products with monofunctional or polyfunctional carboxylic acids are also preferably used. Furthermore, the addition reaction products of unsaturated carboxylic esters or amides having an electrophilic substituent such as an isocyanate group or an epoxy group with monofunctional or polyfunctional alcohols, amines or thiols, and the substitution reaction products of unsaturated carboxylic esters or amides having a separable substituent such as a halogen group or a tosyloxy group with monofunctional or polyfunctional alcohols, amines or thiols are also preferably used. As other examples, it is also possible to use compounds in which these unsaturated carboxylic acids are replaced with unsaturated phosphonic acid, styrene, vinyl ether, etc.

The specific examples of the monomers of esters of aliphatic polyhydric alcohol compounds and unsaturated carboxylic acids include, as acrylic esters, ethylene glycol diacrylate, triethylene glycol diacrylate, 1,3-butanediol diacrylate, tetramethylene glycol diacrylate, propylene glycol diacrylate, neopentyl glycol diacrylate, trimethylolpropane triacrylate, trimethylolpropane tri(acryloyloxypropyl) ether, trimethylolethane triacrylate, hexanediol diacrylate, 1,4-cyclohexanediol diacrylate, tetraethylene glycol diacrylate, pentaerythritol diacrylate, pentaerythritol triacrylate, pentaerythritol tetraacrylate, dipentaerythritol diacrylate, dipentaerythritol hexaacrylate, sorbitol triacrylate, sorbitol tetraacrylate, sorbitol pentaacrylate, sorbitol hexaacrylate, tri(acryloyloxyethyl) isocyanurate, polyester acrylate oligomer, isocyanuric acid EO-modified triacrylate, etc.

As methacrylic esters, the examples include tetramethylene glycol dimethacrylate, triethylene glycol dimethacrylate, neopentyl glycol dimethacrylate, trimethylolpropane trimethacrylate, trimethylolethane trimethacrylate, ethylene glycol dimethacrylate, 1,3-butanediol dimethacrylate, hexanediol dimethacrylate, pentaerythritol dimethacrylate, pentaerythritol trimethacrylate, pentaerythritol tetramethacrylate, dipentaerythritol dimethacrylate, dipentaerythritol hexamethacrylate, sorbitol trimethacrylate, sorbitol tetramethacrylate, bis[p-(3-methacryloxy-2-hydroxypropoxy)- phenyl]dimethylmethane, bis[p-(methacryloxyethoxy)phenyl]- dimethylmethane, etc.

As itaconic esters, the examples include ethylene glycol diitaconate, propylene glycol diitaconate, 1,3-butanediol diitaconate, 1,4-butanediol diitaconate, tetramethylene glycol diitaconate, pentaerythritol diitaconate, sorbitol tetraitaconate, etc. As crotonic esters, the examples include ethylene glycol dicrotonate, tetramethylene glycol dicrotonate, pentaerythritol dicrotonate, sorbitol tetradicrotonate, etc. As isocrotonic esters, the examples include ethylene glycol diisocrotonate, pentaerythritol diisocrotonate, sorbitol tetraisocrotonate, etc. As maleic esters, the examples include ethylene glycol dimaleate, triethylene glycol dimaleate, pentaerythritol dimaleate, sorbitol tetramaleate, etc.

As the examples of other esters, e.g., the aliphatic alcohol esters disclosed in JP-B-51-47334 and JP-A-57-196231, the esters having an aromatic skeleton disclosed in JP-A-59- 5240, JP-A-59-5241 and JP-A-2-226149, and the esters containing an amino group disclosed in JP-A-1-165613 are also preferably used in the invention. The above ester monomers can also be used as mixtures.

Further, the specific examples of the amide monomers of aliphatic polyhydric amine compounds and unsaturated carboxylic acids include methylenebis-acrylamide, methylenebis-methacrylamide, 1,6-hexamethylenebis-acrylamide, 1,6-hexamethylenebis-methacrylamide, diethylenetriaminetris-acrylamide, xylylenebis-acrylamide, xylylenebis-methacrylamide, etc. As the examples of other preferred amide monomers, the monomers having a cyclohexylene structure disclosed in JP-B-54-21726 can be exemplified.

Further, urethane-based addition polymerizable compounds manufactured by the addition reaction of isocyanate and hydroxyl groups are also preferably used. As the specific examples of such compounds, as is disclosed in JP-B-48-41708, a vinyl urethane compound containing two or more polymerizable vinyl groups in one molecule obtained by the addition of vinyl monomer containing a hydroxyl group represented by the following formula (II) to a polyisocyanate compound having two or more isocyanate groups in one molecule is exemplified.

CH₂=C(R₄)COOCH₂CH(R₅)OH (II)

In formula (II), R₄ and R₅ each represents H or CH₃.

The urethane acrylates disclosed in JP-A-51-37193, JP-B-2-32293, and JP-B-2-16765, and the urethane compounds having an ethylene oxide skeleton disclosed in JP-B-58-49860, JP-B-56-17654, JP-B-62-39417 and JP-B-62-39418 are also preferably used in the invention. In addition, very high speed photopolymerizable compositions can be obtained by using addition polymerizable compounds having an amino structure and a sulfide structure in the molecule as disclosed in JP-A-63- 277653, JP-A-63-260909 and JP-A-1-105238.

As other examples, the polyfunctional acrylates and methacrylates, such as polyester acrylates, and epoxy acrylates obtained by the reaction of epoxy resins with (meth)acrylic acids as disclosed in JP-A-48-64183, JP-B-49- 43191 and JP-B-52-30490 can be exemplified. The specific unsaturated compounds disclosed in JP-B-46-43946, JP-B-1-40337 and JP-B-1-40336, and the vinylsulfonic acid compounds disclosed in JP-A-2-25493 can also be exemplified. Further, according to cases, the structures containing a perfluoroalkyl group disclosed in JP-A-61-22048 are preferably used. Moreover, the compounds introduced, as photo-curable monomers and oligomers, into Bulletin of Nippon Setchaku Kyokai, Vol. 20, No. 7, pp. 300-308 (1984) can also be used.

The details in usage of these polymerizable compound, e.g., what a structure is to be used, whether the compound is to be used alone or in combination, or what an amount is to be used, can be optionally set up according to the final design of the performances of the lithographic printing plate precursor. For example, the conditions are selected from the viewpoint as follows. In the point of sensitivity, a structure containing many unsaturated groups per a molecule is preferred, and bifunctional or higher functional groups are preferred in many cases. For increasing the strength of an image part, i.e., a cured film, trifunctional or higher functional groups are preferred, and it is also effective to use different functional numbers and different polymerizable groups (e.g., acrylate, methacrylate, styrene compounds, vinyl ether compounds) in combination to control both speed and strength. Further, the selection and usage of the addition polymerizable compounds are important factors for the compatibility with other components in an image-recording layer (e.g., a binder polymer, a polymerization initiator, a colorant, etc.) and dispersibility, for example, sometimes compatibility can be improved by using a low purity compound or two or more compounds in combination. Further, it is also possible to select a specific structure for the purpose of improving the adhesion property with a substrate and a protective layer described later. The polymerizable compounds are used preferably in the proportion of from 5 to 80 mass% based on the volatile content of the image-recording layer, and more preferably from 25 to 75 mass%. These compounds may be used alone, or two or more compounds may be used in combination. In addition to the above, in connection with the usage of the polymerizable compound, the structure, composition and addition amount can be properly selected in view of the degree of polymerization hindrance by oxygen, resolution, a fogging property, change in refractive index, surface tackiness, etc. Further, in some cases, a layer constitution and a coating method of undercoat and overcoat may be taken.

### <(D) Binder polymer>

As described above, it is necessary that the binder polymers that can be used in the invention should not be dissolved in printing ink and/or a fountain solution within the time required for development. Conventionally known binder polymers can be used in the invention with no restriction so long as the above requisite is satisfied, and linear organic polymers having a film-forming property are preferably used. The examples of such binder polymers include acrylic resins, polyvinyl acetal resins, polyurethane resins, polyamide resins, epoxy resins, methacrylic resins, polystyrene resins, and novolak type phenolic resins.

It is preferred that binder polymers have a crosslinking property for the purpose of improving the layer strength of an image part. For giving a crosslinkable property to binder polymers, it is effective to introduce a crosslinkable functional group such as an ethylenic unsaturated bond into the main chain or side chain of the polymers. The crosslinkable functional group may be introduced by copolymerization. As the examples of polymers having an ethylenic unsaturated bond in the main chain of the molecule, poly-1,4-butadiene, poly-1,4-isoprene, natural rubbers and synthetic rubbers are exemplified.

As the examples of the polymers having an ethylenic unsaturated bond in the side chain of the molecule, polymers of esters or amides of acrylic acid or methacrylic acid, wherein the residue of the ester or amide (R of -COOR or -CONHR) has an ethylenic unsaturated bond are exemplified. As the examples of the residues having an ethylenic unsaturated bond (the above-described R), -(CH₂)ₙCR¹=CR²R³, -(CH₂O)ₙCH₂CR¹=CR²R³, -(CH₂CH₂O)ₙCH₂CR¹=CR²R³, -(CH₂)ₙNH-CO-O-CH₂CR¹=CR²R³, -(CH₂)ₙ-O-CO-CR¹=CR²R³ and -(CH₂CH₂O)₂-X are exemplified (in the formulae, R¹, R² and R³ each represents a hydrogen atom, a halogen atom, an alkyl group having from 1 to 20 carbon atoms, an aryl group, an alkoxyl group or an aryloxy group, and R¹ and R² or R³ may be bonded to each other to form a ring, n represents an integer of from 1 to 10, and X represents a dicyclopentadienyl residue). The specific examples of the ester residues include -CH₂CH=CH₂ (disclosed in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂-NHCOO-CH₂CH=CH₂ and -CH₂CH₂O-X (wherein X represents a dicyclopentadienyl residue). The specific examples of the amido residues include -CH₂CH=CH₂, -CH₂CH₂-Y (wherein Y represents a cyclohexene residue), and -CH₂CH₂-OCO-CH=CH₂.

When free radicals (polymerization initiation radicals or the grown radicals in the polymerization process of a polymerizable compound) are added to the crosslinkable functional groups of a binder polymer having a crosslinking property, addition polymerization occurs directly between the polymers or via the polymerization chains of the polymerizable compound, as a result, crosslinking is formed between the molecules of the polymers, and the binder polymer is hardened. Alternatively, the atoms in the polymer (e.g., the hydrogen atoms on the carbon atoms contiguous to crosslinkable functional groups) are extracted by free radicals and polymer radicals are grown, and the polymer radicals are bonded to each other, whereby crosslinking is formed between the polymer molecules, as a result the binder polymer is hardened. The content of crosslinkable groups in a binder polymer (the content of radical polymerizable unsaturated double bonds by an iodometric titration method) is preferably from 0.1 to 10.0 mmol per gram of the binder polymer, more preferably from 1.0 to 7.0 mmol, and most preferably from 2.0 to 5.5 mmol. Good sensitivity and good preservation stability can be obtained with this range of the content of crosslinkable groups.

Binder polymer (D) preferably has weight average molecular weight of preferably 5,000 or higher, more preferably from 10,000 to 300,000, and number average molecular weight of preferably 1,000 or higher, more preferably from 2,000 to 250,000. The polydisperse degree (weight average molecular weight/number average molecular weight) is preferably from 1.1 to 10.

Binder polymer (D) may be any of random polymers, block polymers, graft polymers, etc., but random polymers or graft polymers are preferred. Binder polymer (D) can be synthesized by conventionally known methods. As the solvents for use in the synthesis, e.g., tetrahydrofuran, ethylene dichloride, cyclohexanone, methyl ethyl ketone, acetone, methanol, ethanol, ethylene glycol monomethyl ether, ethylene glycol monoethyl ether, 2-methoxyethyl acetate, diethylene glycol dimethyl ether, 1-methoxy-2-propanol, 1-methoxy-2-propyl acetate, N,N-dimethylformamide, N,N-dimethylacetamide, toluene, ethyl acetate, methyl lactate, ethyl lactate, dimethyl sulfoxide, and water are exemplified. These solvents may be used alone or two or more solvents may be used as a mixture.

As the radical polymerization initiators used in the synthesis of binder polymer (D), known compounds, e.g., azo initiators and peroxide initiators can be used. Binder polymer (D) may be used singly or in combination of two or more kinds thereof. Binder polymer (D) is used in an amount of preferably from 10 to 90 mass% to all the solids content of the image-recording layer, more preferably from 20 to 80 mass%, and still more preferably from 30 to 70 mass%. When binder polymer (D) is used in this range, good image part strength and good image-forming property can be obtained. It is preferred to use polymerizable compound (C) and binder polymer (D) in mass ratio of from 1/9 to 7/3.

In the invention, as the methods for adding the above constituents (A) to (D) and other constituents described later of image-recording layer to an image-recording layer, some embodiments can be used. One embodiment is a molecular dispersion type image-recording layer of dissolving the constituents in an appropriate solvent and coating as disclosed in JP-A-2002-287334, and another one is a microcapsule type image-recording layer of encapsulating all or a part of the constituents in microcapsules and adding to an image-recording layer as disclosed in JP-A-2001-277740 and JP-A-2001-277742. In addition, in a microcapsule type image-recording layer, the constitutional components may also be contained outside the microcapsules. Here, in a microcapsule type image-recording layer, it is a preferred embodiment to contain hydrophobic constituents in microcapsules and hydrophilic constituents out of microcapsules. Further, as other embodiment, an embodiment of using crosslinking resin particles, i.e., microgels, in an image-recording layer is exemplified. The microgels can contain a part of the above constituents (A) to (D) in the microgels and/or on the surfaces thereof. An embodiment of having polymerizable compound (C) on the surfaces of microgels to thereby make reactive microgels is especially preferred from the points of image forming sensitivity and press life. For obtaining a better on-press developing property, it is advantageous that the image-recording layer is a microcapsule type or microgel type image-recording layer.

The constitutional components of an image-recording layer can be microencapsulated or micro-gelatinized by known methods.

As the manufacturing methods of microcapsules, the method making use of coacervation as disclosed in U.S. Patents 2,800,457 and 2,800,458, the method by interfacial polymerization as disclosed in U.S. Patent 3,287,154, JP-B-38-19574 and JP-B-42-446, the method by the precipitation of a polymer as disclosed in U.S. Patents 3,418,250 and 3,660,304, the method of using isocyanate polyol wall materials as disclosed in U.S. Patent 3,796,669, the method of using isocyanate wall materials as disclosed in U.S. Patent 3,914,511, the method of using urea-formaldehyde or urea-formaldehyde- resorcinol wall materials as disclosed in U.S. Patents 4,001,140, 4,087,376 and 4,089,802, the method of using melamine-formaldehyde resins or hydroxy cellulose wall materials as disclosed in U.S. Patent 4,025,445, the in situ method by monomer polymerization as disclosed in JP-B-36-9163 and JP-B-51-9079, the spray drying method as disclosed in British Patent 930,422 and U.S. Patent 3,111,407, and the electrolytic dispersion cooling method as disclosed in British Patents 952,807 and 967,074 can be exemplified, but the invention is by no means restricted to these methods.

The microcapsule walls preferably used in the invention have three dimensional crosslinking and a property of swelling by a solvent. From this point of view, polyurea, polyurethane, polyester, polycarbonate, polyamide, and the mixtures of these compounds are preferably used as microcapsule wall materials, and polyurea and polyurethane are especially preferred. Compounds having crosslinkable functional groups such as ethylenic unsaturated bonds that can introduce the above binder polymer (D) may be introduced into a microcapsule wall.

On the other hand, as methods of preparing microgels, it is possible to use granulation by interfacial polymerization as disclosed in JP-B-38-19574 and JP-B-42-446, and granulation by nonaqueous dispersion polymerization as disclosed in JP-A-5-61214, but the invention is not restricted to these methods. The above microcapsule manufacturing methods can be applied to the method utilizing interfacial polymerization.

The microgels preferably used in the invention have three dimensional crosslinking granulated by interfacial polymerization. From this point of view, materials such as polyurea, polyurethane, polyester, polycarbonate, polyamide, and mixtures of these materials are preferably used, and polyurea and polyurethane are especially preferably used.

The average particle size of the microcapsules and microgels is preferably from 0.01 to 3.0 µm, more preferably from 0.05 to 2.0 µm, and especially preferably from 0.10 to 1.0 µm. With this range of the average particle size, good resolution and aging stability can be obtained.

### <Surfactant>

In the invention, it is preferred to use a surfactant in an image-recording layer to accelerate the on-press development property at the time of starting printing and to improve the conditions of coating surface. As the surfactants, nonionic surfactants, anionic surfactants, cationic surfactants, ampholytic surfactants and fluorine surfactants are used. Surfactants may be used alone or two or more surfactants may be used in combination.

The nonionic surfactants for use in the invention are not particularly restricted and conventionally well known surfactants can be used, e.g., polyoxyethylene alkyl ethers, polyoxyethylene alkyl phenyl ethers, polyoxyethylene polystyryl phenyl ethers, polyoxyethylene polyoxypropylene alkyl ethers, glycerol fatty acid partial esters, sorbitan fatty acid partial esters, pentaerythritol fatty acid partial esters, propylene glycol monofatty acid esters, sucrose fatty acid partial esters, polyoxyethylene sorbitan fatty acid partial esters, polyoxyethylene sorbitol fatty acid partial esters, polyethylene glycol fatty acid esters, polyglycerol fatty acid partial esters, polyoxyethylenated castor oils, polyoxyethylene glycerol fatty acid partial esters, fatty acid diethanolamides, N,N -bis-2-hydroxyalkylamines, polyoxyethylene alkylamine, triethanolamine fatty acid ester, trialkylamine oxide, polyethylene glycol, and copolymers of polyethylene glycol and polypropylene glycol are exemplified.

The anionic surfactants for use in the invention are not particularly restricted and conventionally well known surfactants can be used, e.g., fatty acid salts, abietates, hydroxyalkanesulfonates, alkanesulfonates, dialkylsulfo- succinates, straight chain alkylbenzenesulfonates, branched chain alkylbenzenesulfonates, alkylnaphthalenesulfonates, alkylphenoxypolyoxyethylenepropylsulfonates, polyoxy- ethylene alkyl sulfophenyl ethers, sodium N-methyl-N-oleyl- taurine, disodium N-alkylsulfosuccinic acid monoamide, petroleum sulfonates, sulfated beef tallow, sulfuric esters of fatty acid alkyl ester, alkylsulfuric esters, polyoxyethylene alkyl ether sulfuric esters, fatty acid monoglyceride sulfuric esters, polyoxyethylene alkyl phenyl ether sulfuric esters, polyoxyethylene styryl phenyl ether sulfuric esters, alkylphosphoric esters, polyoxyethylene alkyl ether phosphoric esters, polyoxyethylene alkyl phenyl ether phosphoric esters, partial saponification products of styrene/maleic anhydride copolymers, partial saponification products of olefin/maleic anhydride copolymer, and naphthalene sulfonate formaldehyde condensation products are exemplified.

The cationic surfactants for use in the invention are not particularly restricted and conventionally well known surfactants can be used, e.g., alkylamine salts, quaternary ammonium salts, polyoxyethyene alkylamine salts, and polyethylene polyamine derivatives are exemplified. The amphoteric surfactants for use in the invention are not particularly restricted and conventionally well known surfactants can be used, e.g., carboxybetaines, amino- carboxylic acids, sulfobetaines, aminosulfuric esters and imidazolines are exemplified.

In the above surfactants, "polyoxyethylene" can be taken as "polyoxyalkylene" such as polyoxymethylene, polyoxy- propylene, or polyoxybutylene, and these surfactants can also be used in the invention.

As more preferred surfactants, fluorine surfactants containing a perfluoroalkyl group in the molecule are exemplified. As such fluorine surfactants, anionic surfactants, e.g., perfluoroalkylcarboxylate, perfluoro- alkylsulfonate, perfluoroalkylphosphate, etc.; amphoteric surfactants, e.g., perfluoroalkylbetaine, etc.; cationic surfactants, e.g., perfluoroalkyltrimethylammonium salt, etc.; and nonionic surfactants, e.g., perfluoroalkylamine oxide, perfluoroalkyl ethylene oxide adducts, oligomers containing a perfluoroalkyl group and a hydrophilic group, oligomers containing a perfluoroalkyl group and a lipophilic group, oligomers containing a perfluoroalkyl group, a hydrophilic group, and a lipophilic group, urethane containing a perfluoroalkyl group and a lipophilic group, etc., are exemplified. Further, the fluorine surfactants disclosed in JP-A-62-170950, JP-A-62-226143 and JP-A-60-168144 are also preferably used.

Surfactants can be used alone, or two or more surfactants can be used in combination. The content of surfactants is preferably from 0.001 to 10 mass% based on all the solids content of the image-recording layer, and more preferably from 0.01 to 5 mass%.

### <Colorant>

Further, if necessary, various compounds besides the above compounds can be used in the invention. For example, dyes having large absorption in the visible ray region can be used as the colorants of images. Specifically, Oil Yellow #101, Oil Yellow #103, Oil Pink #312, Oil Green BG, Oil Blue BOS, Oil Blue #603, Oil Black BY, Oil Black BS, Oil Black T-505 (products of Orient Chemical Industries, Ltd.), Victoria Pure Blue, Crystal Violet (C.I. 42555), Methyl Violet (C.I. 42535), Ethyl Violet, Rhodamine B (C.I. 145170B), Malachite Green (C.I. 42000), Methylene Blue (C.I. 52015), etc., and the dyes disclosed in JP-A-62-293247 can be exemplified. In addition, pigments such as phthalocyanine pigments, azo pigments, carbon black, titanium oxide, etc., are also preferably used. These colorants are preferably added, since discrimination of an image part from a non-image part after image formation becomes easy. The addition amount of colorants is preferably in the proportion of from 0.01 to 10 mass% of all the solids content of the image-recording materials.

### <Printing-out agent>

Compounds that discolor by acids or radicals can be added to an image-recording layer in the invention for forming a printing out image. As such compounds, various dyestuffs, e.g., diphenylmethane, triphenylmethane, thiazine, oxazine, xanthene, anthraquinone, iminoquinone, azo, and azomethine dyestuffs are effectively used.

The specific examples of such dyestuffs include dyes such as Brilliant Green, Ethyl Violet, Methyl Green, Crystal Violet, Basic Fuchsine, Methyl Violet 2B, Quinaldine Red, Rose Bengal, Metanil Yellow, Thymolsulfophthalein, Xylenol Blue, Methyl Orange, Paramethyl Red, Congo Fred, Benzopurpurine 4B, α-Naphthyl Red, Nile Blue 2B, Nile Blue A, Methyl Violet, Malachite Green, Parafuchsine, Victoria Pure Blue BOH (products of HODOGAYA CHEMICAL CO., LTD.), Oil Blue #603 (a product of Orient Chemical Industries, Ltd.), Oil Pink #312 (a product of Orient Chemical Industries, Ltd.), Oil Red 5B (a product of Orient Chemical Industries, Ltd.), Oil Scarlet #308 (a product of Orient Chemical Industry Co., Ltd.), Oil Red OG (a product of Orient Chemical Industries, Ltd.), Oil Red RR (a product of Orient Chemical Industries, Ltd.), Oil Green #502 (a product of Orient Chemical Industries, Ltd.), Spiron Red BEH Special (a product of HODOGAYA CHEMICAL CO., LTD.), m-Cresol Purple, Cresol Red, Rhodamine B, Rhodamine 6G, Sulforhodamine B, Auramine, 4-p-diethylaminophenylimino-naphthoquinone, 2-carboxyanilino-4-p-diethylaminophenyl-iminonaphthoquinone, 2-carboxystearylamino-4-p-N,N-bis-(hydroxyethyl)aminophenyliminonaphthoquinone, 1-phenyl-3-methyl-4-p-diethylaminophenylimino-5-pyrazolone, 1-β-naphthyl-4-p-diethylaminophenylimino-5-pyrazolone, etc., and leuco dyes such as p,p',p"-hexamethyltriaminotriphenyl-methane (Leuco Crystal Violet), Pergascript Blue SRB (a product of by Ciga Geigy A.G.), etc.

In addition to the above, leuco dyes known as the materials of heat-sensitive paper and pressure-sensitive paper are also preferably exemplified. The specific examples of the leuco dyes include Crystal Violet Lactone, Malachite Green Lactone, Benzoyl Leuco Methylene Blue, 2-(N-phenyl-N-methylamino)-6-(N-p-tolyl-N-ethyl)aminofluoran, 2-anilino-3-methyl-6-(N-ethyl-p-toluidino)fluoran, 3,6-dimethoxy-fluoran, 3-(N,N-diethyIamino)-5-methyl-7-(N,N-dibenzyI-amino)fluoran, 3-(N-cyclohexyl-N-methylamino)-6-methyl-7-anilinofluoran, 3-(N,N-diethylamino)-6-methyl-7-anilino-fluoran, 3-(N,N-diethylamino)-6-methyl-7-xylidinofluoran, 3-(N,N-diethylamino)-6-methyl-7-chlorofluoran, 3-(N,N-diethylamino)-6-methoxy-7-aminofluoran, 3-(N,N-diethyl-amino)-7-(4-chloroanilino)fluoran, 3-(N,N-diethylamino)-7- chlorofluoran, 3-(N,N-diethylamino)-7-benzylaminofluoran, 3-(N,N-diethylamino)-7,8-benzofluoran, 3-(N,N-dibutyl-amino)-6-methyl-7-anilinofluoran, 3-(N,N-dibutylamino)-6-methyl-7-xylidinofluoran, 3-piperidino-6-methyl-7-anilino-fluoran, 3-pyrrolidino-6-methyl-7-anilinofluoran, 3,3-bis-(1-ethyl-2-methylindol-3-yl)phthalide, 3,3-bis(1-n-butyl-2-methylindol-3-yl)phthalide, 3,3-bis(p-dimethylaminophenyl)-6-dimethylaminophthalide, 3-(4-diethylamino-2-ethoxy-phenyl)-3-(1-ethyl-2-methylindol-3-yl)-4-zaphthalide, 3-(4-diethylaminophenyl)-3-(1-ethyl-2-methylindol-3-yl)-phthalide, etc.

The dyes that discolor by acids or radicals are preferably added in the proportion of from 0.01 to 10 mass% to the solids content of the image-recording layer.

### <Polymerization inhibitor>

For the prevention of unnecessary thermal polymerization of polymerizable compound (C) during the manufacture or preservation of an image-recording layer, it is preferred that a small amount of a thermal polymerization inhibitor be added to the image-recording layer in the invention. As the examples of thermal polymerization inhibitors, e.g., hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol), and N-nitroso-N-phenylhydroxylamine aluminum salt are preferably exemplified. The addition amount of the thermal polymerization inhibitors is preferably from about 0.01 to about 5 mass% to all the solids content of the image-recording layer.

### <Higher fatty acid derivative, etc.>

For the prevention of the polymerization hindrance due to oxygen, higher fatty acid derivatives, such as behenic acid and behenic acid amide may be added to an image-recording layer in the invention to locally exist on the surface of the image-recording layer in the drying process after coating. The addition amount of the higher fatty acid derivatives is preferably from about 0.1 to about 10 mass% to all the solids content of the image-recording layer.

### <Plasticizer>

An image-recording layer in the invention may contain a plasticizer for the purpose of improvement of an on-press developing property. The examples of plasticizers include phthalic esters, e.g., dimethyl phthalate, diethyl phthalate, dibutyl phthalate, diisobutyl phthalate, dioctyl phthalate, octylcapryl phthalate, dicyclohexyl phthalate, ditridecyl phthalate, butylbenzyl phthalate, diisodecyl phthalate, diallyl phthalate, etc.; glycol esters, e.g., dimethyl glycol phthalate, ethyl phthalyl ethyl glycolate, methyl phthalyl ethyl glycolate, butyl phthalyl butyl glycolate, triethylene glycol dicaprylate, etc.; phosphoric esters, e.g., tricresyl phosphate, triphenyl phosphate, etc.; aliphatic dibasic esters, e.g., diisobutyl adipate, dioctyl adipate, dimethyl sebacate, dibutyl sebacate, dioctyl azelate, dibutyl maleate, etc.; and polyglycidyl methacrylate, triethyl citrate, glycerol triacetyl ester, butyl laurate, etc.. The content of plasticizers is preferably about 30 mass% or less to all the solids content of the image-recording layer.

### <Inorganic fine particles>

An image-recording layer in the invention may contain inorganic fine particles for the purposes of increasing the strength of the hardened film of the image part and improving on-press developing properties of the non-image part. As the inorganic fine particles, e.g., silica, alumina, magnesium oxide, titanium oxide, magnesium carbonate, calcium alginate and mixtures of these fine particles are preferably exemplified. These inorganic fine particles can be used for strengthening a film and enhancing an interface adhesion property by surface roughening treatment even when they are not light-heat convertible. The average particle size of inorganic fine particles is preferably from 5 nm to 10 µm, and more preferably from 0.5 to 3 µm. When the average particle size is in the above range, inorganic fine particles are stably dispersed in the image-recording layer and the film strength of the image-recording layer can be sufficiently retained, thus a non-image part difficult to be soiled in printing and excellent in hydrophilicity can be formed. These inorganic fine particles are easily available as commercial products such as colloidal silica dispersion and the like. The content of inorganic fine particles is preferably 20 mass% or less to all the solids content of the image-recording layer, and more preferably 10 mass% or less.

### <Hydrophilic low molecular weight compound>

For the improvement of an on-press developing property, an image-recording layer in the invention can contain hydrophilic low molecular weight compounds. As the hydrophilic low molecular weight compounds, water-soluble organic compounds, such as glycols, e.g., ethylene glycol, diethylene glycol, triethylene glycol, propylene glycol, dipropylene glycol, tripropylene glycol, etc., and ether or ester derivatives thereof, polyhydroxies, e.g., glycerol, pentaerythritol, etc., organic amines, e.g., triethanolamine, diethanolamine, monoethanolamine, etc., and salts thereof, organic sulfonic acids, e.g., toluenesulfonic acid, benzenesulfonic acid, etc., and salts thereof, organic phosphonic acids, e.g., phenylphosphonic acid, etc., and salts thereof, and organic carboxylic acids, e.g., tartaric acid, oxalic acid, citric acid, malic acid, lactic acid, gluconic acid, amino acid, etc., and salts thereof are exemplified.

### <Formation of image-recording layer>

An image-recording layer in the invention is formed by coating a coating solution prepared by dispersing or dissolving the above necessary constitutional components in a solvent. As solvents used here, ethylene dichloride, cyclohexanone, methyl ethyl ketone, methanol, ethanol, propanol, ethylene glycol monomethyl ether, 1-methoxy-2-propanol, 2-methoxy- ethyl acetate, 1-methoxy-2-propyl acetate, dimethoxyethane, methyl lactate, ethyl lactate, N,N-dimethylacetamide, N,N-dimethylformamide, tetramethylurea, N-methylpyrrolidone, dimethyl sulfoxide, sulforan, γ-butyrolactone, toluene, and water are exemplified, but solvents are not limited thereto. These solvents are used alone or as mixture. The concentration of the solid contents of a coating solution is preferably from 1 to 50 mass%. It is also possible to form the image-recording layer in the invention by preparing a plurality of coating solutions by dispersing or dissolving the same or different components in the same or different solvents, and repeating the coating and drying a plurality of times.

Although the coating amount of an image-recording layer (solids content) on a support obtained after coating and drying varies according to uses, it is generally preferably from 0.3 to 3.0 g/m². When the coating amount is in this range, good sensitivity and good film properties of the image-recording layer can be obtained. Various coating methods can be used. For example, bar coater coating, rotary coating, spray coating, curtain coating, dip coating, air knife coating, blade coating, and roll coating can be exemplified.

### <Support>

Supports for use in a lithographic printing plate precursor in the invention are not especially restricted and any supports can be used so long as they are dimensionally stable and plate-like supports. For example, paper, paper laminated with plastics (e.g., polyethylene, polypropylene, polystyrene, etc.), metal plates (e.g., aluminum, zinc, copper, etc.), plastic films (e.g., cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate, polyvinyl acetal, etc.), and paper and plastic films laminated or deposited with the above metals can be exemplified. Preferred supports are a polyester film and an aluminum plate. Above all, aluminum plates, which are dimensionally stable and comparatively inexpensive, are preferred.

Aluminum plates are a pure aluminum plate, alloy plates containing aluminum as the main component and a trace amount of different elements, and aluminum or aluminum alloy thin films laminated with plastics. The examples of different elements contained in aluminum alloys include silicon, iron, manganese, copper, magnesium, chromium, zinc, bismuth, nickel, titanium, etc. The content of different elements in aluminum alloys is preferably 10 mass% or less. In the invention, a pure aluminum plate is preferred but 100% pure aluminum is difficult to manufacture from the refining technique, so that an extremely small amount of different elements may be contained. The compositions of aluminum plates used in the invention are not specified, and aluminum plates of conventionally known and commonly used materials can be optionally used.

A support for use in the invention has a thickness of preferably from 0.1 to 0.6 mm, more preferably from 0.15 to 0.4 mm, and still more preferably from 0.2 to 0.3 mm.

Prior to the use of an aluminum plate, it is preferred for the aluminum plate to be subjected to surface treatment, such as surface roughening treatment and anodizing treatment. By surface treatment, the improvement of hydrophilicity and the security of the adhesion of the image-recording layer and a support become easy. Prior to the surface roughening treatment of an aluminum plate, if necessary, degreasing treatment with a surfactant, an organic solvent or an alkaline aqueous solution is carried out to remove the rolling oil on the surface of the aluminum plate.

Surface roughening treatment of the surface of an aluminum plate is performed by various methods, e.g., mechanical surface roughening treatment, electrochemical surface roughening treatment (surface roughening treatment of electrochemically dissolving the surface), and chemical surface roughening treatment (surface roughening treatment of chemically selectively dissolving the surface) are exemplified. As the method of mechanical surface roughening treatment, well-known methods, e.g., a ball rubbing method, a brush abrading method, a blast abrading method, or a buffing method, can be used. As the method of electrochemical surface roughening treatment, a method of roughening in an electrolyte containing an acid such as a hydrochloric acid, a nitric acid, etc., by alternating current or direct current can be used. Further, a method of using mixed acids can also be used as disclosed in JP-A-54-63902.

An aluminum plate subjected to surface roughening treatment is, if necessary, subjected to alkali etching treatment with an aqueous solution of potassium hydroxide, sodium hydroxide, etc., and neutralizing treatment and then, according to necessity, to anodizing treatment to increase the abrasion resistance of the surface.

Various electrolytes can be used in the anodizing treatment of an aluminum plate for forming porous oxide film, and a sulfuric acid, a hydrochloric acid, an oxalic acid, a chromic acid or mixed acid of these acids is generally used. The concentrations of these electrolytes are arbitrarily determined according to the kinds of electrolytes. Anodizing treatment conditions vary according to electrolytes used, so that the conditions cannot be specified unconditionally, but in general preferably the concentration of an electrolytic solution is from 1 to 80 mass%, the liquid temperature is from 5 to 70°C, the electric current density is from 5 to 60 A/dm², the voltage is from 1 to 100 V, the electrolytic time is from 10 seconds to 5 minutes. The amount of the anodic oxide film to be formed is preferably from 1.0 to 5.0 g/m², and more preferably from 1.5 to 4.0 g/m². In this range of the amount of the anodic oxide film, good press life and good scratch resistance of the non-image part of the lithographic printing plate can be obtained.

As the support for use in the invention, the supports subjected to surface treatments as above and having an anodic oxide film may be used as they are, but for further enhancing the adhesion with the upper layer, a hydrophilic property, soiling resistance and a heat insulating property, enlarging treatment of the micro-pores of the anodic oxide film, sealing treatment of the micro-pores, and hydrophilization treatment of the surface by immersion in an aqueous solution containing a hydrophilic compound as disclosed in JP-A-2001-253181 and JP-A-2001-322365 can be arbitrarily performed, if necessary. These enlarging treatment and sealing treatment are of course not restricted to the methods disclosed in the above patents, and any of conventionally known methods can be used. For example, besides sealing treatment with steam, the sealing treatment may be treatment with fluorozirconic acid alone, treatment with sodium fluoride, or sealing treatment with steam having added thereto lithium chloride.

### <Sealing treatment>

Sealing treatments for use in the invention are not especially restricted and conventionally well known methods can be used, but sealing treatment with an aqueous solution containing an inorganic fluorine compound, sealing treatment with water vapor, and sealing treatment with hot water are preferred. Each treatment is described below.

As the inorganic fluorine compounds for use in the sealing treatment with an aqueous solution containing an inorganic fluorine compound, metal fluorides are preferably exemplified. Specifically, e.g., sodium fluoride, potassium fluoride, calcium fluoride, magnesium fluoride, sodium fluorozirconate, potassium fluorozirconate, sodium fluorotitanate, potassium fluorotitanate, ammonium fluorozirconate, ammonium fluorotitanate, potassium fluorotitanate, fluoro- zirconic acid, fluorotitanic acid, hexafluorosilicic acid, nickel fluoride, iron fluoride, fluorophosphoric acid, and ammonium fluorophosphate are exemplified. Of these metal fluorides, sodium fluorozirconate, sodium fluorotitanate, fluorozirconic acid, and fluorotitanic acid are preferred.

The concentration of an inorganic fluorine compound in an aqueous solution is preferably 0.01 mass% or more for sufficiently sealing the micro-pores of an anodic oxide film, and more preferably 0.05 mass% or more. The concentration is preferably 1 mass% or less in the aspect of staining resistance, and more preferably 0.5 mass% or less.

It is preferred for an aqueous solution containing an inorganic fluorine compound to further contain a phosphate compound. By containing a phosphate compound, the hydrophilic property of the surface of an anodic oxide film is improved, so that on-press developing property and staining resistance can be bettered.

As the phosphate compounds, the phosphate of metals of, e.g., alkali metals and alkaline earth metals are preferably exemplified. Specifically, zinc phosphate, aluminum phosphate, ammonium phosphate, diammonium hydrogenphosphate, ammonium dihydrogenphosphate, monoammonium phosphate, monopotassium phosphate, monosodium phosphate, potassium dihydrogenphosphate, dipotassium hydrogenphosphate, calcium phosphate, sodium ammonium hydrogenphosphate, magnesium hydrogenphosphate, magnesium phosphate, ferrous phosphate, ferric phosphate, sodium dihydrogenphosphate, sodium phosphate, disodium hydrogenphosphate, lead phosphate, diammonium phosphate, calcium dihydrogenphosphate, lithium phosphate, phosphowolframic acid, ammonium phosphowolframate, sodium phosphowolframate, ammonium phosphomolybdate, sodium phosphomolybdate, sodium phosphite, sodium tripolyphosphate, and sodium pyrophosphate are exemplified. Of these compounds, sodium dihydrogenphosphate, disodium hydrogenphosphate, potassium dihydrogenphosphate and dipotassium hydrogen- phosphate are preferred. The combination of an inorganic fluorine compound and a phosphate compound is not especially restricted, but it is preferred for the aqueous solution to contain at least sodium fluorozirconate as the inorganic fluorine compound and at least sodium dihydrogenphosphate as the phosphate compound.

The concentration of the phosphate compound in the aqueous solution is preferably 0.01 mass% or more from the point of improving an on-press developing property and soiling resistance, and more preferably 0.1 mass% or more, and from the point of solubility the concentration is preferably 20 mass% or less, and more preferably 5 mass% or less.

The concentration of each compound in the aqueous solution is not especially restricted but the mass ratio of the inorganic fluorine compound and the phosphate compound is preferably from 1/200 to 10/1, and more preferably from 1/30 to 2/1. The temperature of the aqueous solution is preferably 20°C or more, more preferably 40°C or more, and preferably 100°C or less, and more preferably 80°C or less. The pH of the aqueous solution is preferably 1 or more, more preferably 2 or more, and preferably 11 or less, and more preferably 5 or less.

The method of sealing treatment using the aqueous solution containing the inorganic fluorine compound is not particularly restricted and, e.g., an immersing method and a spraying method are exemplified. These methods may be carried out one time or a plurality of times alone, or two or more methods may be combined. An immersing method is especially preferred. When sealing treatment is performed with an immersing method, treatment time is preferably 1 second or longer, more preferably 3 seconds or longer, and preferably 100 seconds or shorter, more preferably 20 seconds or shorter.

As the sealing treatment with aqueous vapor, e.g., a method of applying aqueous vapor to an anodic oxide film continuously or intermittently under pressure or normal pressure is exemplified. The temperature of aqueous vapor is preferably 80°C or more, more preferably 95°C or higher, and preferably 105°C or lower. The pressure of aqueous vapor is preferably in the range of from (atmospheric pressure - 50 mmAq) to (atmospheric pressure + 300 mmAq) (1.008 × 10⁵ to 1.043 × 10⁵ Pa). Further, the time of application of aqueous vapor is preferably 1 second or longer, more preferably 3 seconds or longer, and preferably 100 seconds or shorter, more preferably 20 seconds or shorter.

As the sealing treatment with hot water, e.g., a method of immersing an aluminum plate on which an anodic oxide film is formed in hot water is exemplified. The hot water may contain an inorganic salt (e.g., a phosphate) or an organic salt. The temperature of hot water is preferably 80°C or more, more preferably 95°C or higher, and preferably 100°C or lower. The time of immersion in hot water is preferably 1 second or longer, more preferably 3 seconds or longer, and preferably 100 seconds or shorter, more preferably 20 seconds or shorter.

### <Hydrophilization treatment>

As the hydrophilization treatment, alkali metal silicate methods as disclosed in U.S. Patents 2,714,066, 3,181,461, 3,280,734 and 3,902,734 are known. These methods comprise immersion treatment of a support in an aqueous solution of sodium silicate, etc., or electrolytic processing. In addition, a method of treatment with potassium fluorozirconate as disclosed in JP-B-36-22063, and methods of treatment with polyvinylphosphonic acid as disclosed in U.S. Patents 3,276,868, 4,153,461 and 4,689,272 are exemplified.

When a polyester film or the like that is insufficient in a hydrophilic property of surface is used as a support in the invention, it is preferred to coat a hydrophilic layer to make the surface hydrophilic. As the hydrophilic layers, a hydrophilic layer formed by coating a coating solution containing the colloid of oxide or hydroxide of at least one element selected from beryllium, magnesium, aluminum, silicon, titanium, boron, germanium, tin, zirconium, iron, vanadium, antimony and transition metals as disclosed in JP-A-2001- 199175, a hydrophilic layer having an organic hydrophilic matrix obtained by the crosslinking or pseudo-crosslinking of an organic hydrophilic polymer as disclosed in JP-A-2002-79772, a hydrophilic layer having an inorganic hydrophilic matrix obtained by sol/gel conversion comprising hydrolysis and condensation reaction of polyalkoxysilane, titanate, zirconate or aluminate, and a hydrophilic layer comprising an inorganic thin film having a surface containing a metallic oxide are preferred. Of these hydrophilic layers, a hydrophilic layer formed by coating a coating solution containing the colloid of oxide or hydroxide of silicon is preferred.

When a polyester film is used as a support in the invention, it is preferred to provide an antistatic layer on the hydrophilic layer side of the support, or on the opposite side to the hydrophilic layer, or on both sides. When an antistatic layer is provided between a support and a hydrophilic layer, the antistatic layer also contributes to the adhesion of the hydrophilic layer and the support. As the antistatic layers, polymer layers containing the dispersion of metallic oxide fine particles and a matting agent as disclosed in JP-A-2002-79772 can be used.

It is preferred that a support for use in the invention has a central line average surface roughness of from 0.10 to 1.2 µm. In this range of the average surface roughness, good adhesion of the support and an image-recording layer, good press life and good soiling resistance can be obtained. The color density of a support is preferably from 0.15 to 0.65 in terms of a reflection density value. A good image forming property due to antihalation at the time of image exposure and a good plate-detecting property after development can be obtained when the color density of a support is in this range.

### <Back coat layer>

After surface treatment of a support or after forming an undercoat layer, if necessary, a back coat can be provided on the back surface of the support. As the back coat, e.g., coating layers comprising organic polymer compounds as disclosed in JP-A-5-45885, and coating layers comprising metallic oxides obtained by hydrolysis and polycondensation of organic metallic compounds or inorganic metallic compounds as disclosed in JP-A-6-35174 are preferably used. Alkoxy compounds of silicon, e.g., Si(OCH₃)₄, Si(OC₂H₅)₄, Si(OC₃H₇)₄, Si(OC₄H₉)₄, are preferably used for the inexpensiveness and easy availability of the materials.

### <Undercoat layer>

In the lithographic printing plate precursor in the invention, in particular in the case of an on-press developing type lithographic printing plate precursor, if necessary, an undercoat layer can be provided between an image-recording layer and a support. The image-recording layer comes to be easily peeled off the support at an unexposed part by the undercoat layer, so that the on-press developing property is improved. In the case of infrared laser exposure, since the undercoat layer functions as a heat-insulating layer, the heat generated by exposure does not diffuse to the support and efficiently utilized, so that the improvement of sensitivity can be contrived. As the undercoat layer, specifically silane coupling agents having an addition polymerizable ethylenic double bond reactive group as disclosed in JP-A-10-282679, and phosphorus compounds having an ethylenic double bond reactive group as disclosed in JP-A-2-304441 are preferably exemplified. As the most preferred undercoat layers, polymer resins obtained by copolymerization of a monomer having an adsorptive group/a monomer having a hydrophilic group/a monomer having a crosslinking group can be exemplified.

The essential component of polymer undercoating is an adsorptive group onto a hydrophilic support surface. The presence or absence of adsorptivity onto a hydrophilic support surface can be judged according to the following method. A coating solution is prepared by dissolving a test compound in an easily dissolving solvent, and the resulting coating solution is coated on a support in a dry coating weight of 30 mg/m² and dried. The support coated with the test compound is thoroughly washed with the easily dissolving solvent, and the residual amount of the test compound not removed by washing is measured, from which the amount of the compound adsorbed onto the support is computed. The residual amount may be determined by directly measuring the amount of the residual compound, or may be computed from the determination of the amount of the test compound dissolved in the washing solution. The determination of the compound can be performed by fluorescent X-ray measurement, reflective spectral absorbance measurement, and liquid chromatography measurement. A compound having adsorptivity onto a support is a compound that remains by 1 mg/m² or more after washing as above.

Adsorptive groups onto a hydrophilic support surface are functional groups capable of causing chemical bonding (e.g., ionic bonding, hydrogen bonding, coordinate bonding, bonding by intermolecular force) with the substances present on a hydrophilic support surface (e.g., metal, metallic oxide) or functional groups (e.g., a hydroxyl group). The adsorptive groups are preferably an acid radical or a cationic group. The acid radical has an acid dissociation constant (pKa) of preferably 7 or less. The examples of acid radicals include a phenolic hydroxyl group, a carboxyl group, -SO₃H, -OSO₃H, -PO₃H₂, -OPO₃H₂, -CONHSO₂-, -SO₂NHSO₂-, and -COCH₂COCH₃, and -OPO₃H₂ and -PO₃H₂ are especially preferred. These acid radicals may also be metal salts. The cationic groups are preferably onium groups. The examples of onium groups include an ammonium group, a phosphonium group, an arsonium group, a stibonium group, an oxonium group, a sulfonium group, a selenonium group, a stannonium group, and an iodonium group. An ammonium group, a phosphonium group and a sulfonium group are preferred, and an ammonium group and a phosphonium group are more preferred, and an ammonium group is most preferred.

As especially preferred examples of monomers having an adsorptive group, the compounds represented by the following formula (IV) or (V) are exemplified.

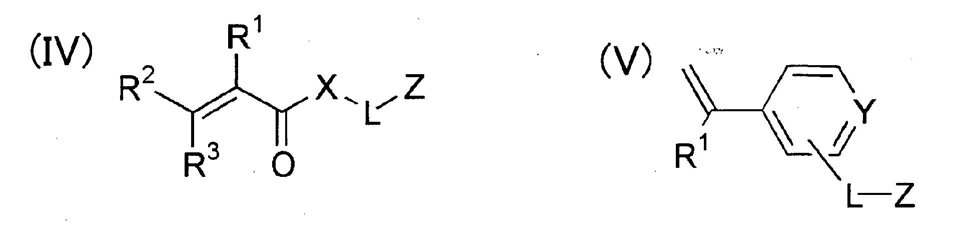

In formula (IV), R¹, R² and R³ each represents a hydrogen atom, a halogen atom, or an alkyl group having from 1 to 6 carbon atoms. R¹, R² and R³ each preferably represents a hydrogen atom or an alkyl group having from 1 to 6 carbon atoms, more preferably represents a hydrogen atom or an alkyl group having from 1 to 3 carbon atoms, and most preferably a hydrogen atom or a methyl group. R² and R³ each especially preferably represents a hydrogen atom. In formula (IV), X represents an oxygen atom (-O-) or an imino group (-NH-), and X more preferably represents an oxygen atom. In formula (IV), L represents a divalent linking group. L preferably represents a divalent aliphatic group (an alkylene group, a substituted alkylene group, an alkenylene group, a substituted alkenylene group, an alkynylene group, a substituted alkynylene group), a divalent aromatic group (an arylene group, a substituted arylene group), or a divalent heterocyclic group, or combinations of these divalent groups with an oxygen atom (-O-), a sulfur atom (-S-), imino (-NH-), substituted imino (-NR-, where R represents an aliphatic group, an aromatic group or a heterocyclic group), or carbonyl (-CO-). The aliphatic group may have a cyclic structure or a branched structure. The number of carbon atoms of the aliphatic group is preferably from 1 to 20, more preferably from 1 to 15, and most preferably from 1 to 10. As the aliphatic group, a saturated aliphatic group is preferred to an unsaturated aliphatic group. The aliphatic group may have a substituent. The examples of the substituents include a halogen atom, a hydroxyl group, an aromatic group and a heterocyclic group. The number of carbon atoms of the aromatic group is preferably from 6 to 20, more preferably from 6 to 15, and most preferably from 6 to 10. The aromatic group may have a substituent. The examples of the substituents include a halogen atom, a hydroxyl group, an aliphatic group, an aromatic group and a heterocyclic group. It is preferred for the heterocyclic group to have a 5- or 6-membered ring as a heterocyclic ring. Other heterocyclic ring, an aliphatic ring or an aromatic ring may be condensed with the heterocyclic ring. The heterocyclic group may have a substituent. The examples of the substituents include a halogen atom, a hydroxyl group, an oxo group (=O), a thioxo group (=S), an imino group (=NH), a substituted imino group (=N-R, where R represents an aliphatic group, an aromatic group or a heterocyclic group), an aliphatic group, an aromatic group, and a heterocyclic group. L is preferably a divalent linking group containing a plurality of polyoxyalkylene structures. The polyoxyalkylene structures are more preferably polyoxy- ethylene structures. In other words, it is preferred for L to contain -(OCH₂CH₂)ₙ- (n is an integer of 2 or more). In formula (IV), Z represents a functional group adsorptive onto the surface of a hydrophilic support.

In formula (V), R¹, L and Z have the same meaning as in formula (IV). Y represents a carbon atom or a nitrogen atom. In the case where Y is a nitrogen atom and L is linked onto Y to form a quaternary pyridinium group, the group itself shows adsorptivity, so that Z is not essential.

The representative examples of the monomers represented by formula (IV) or (V) are shown below.

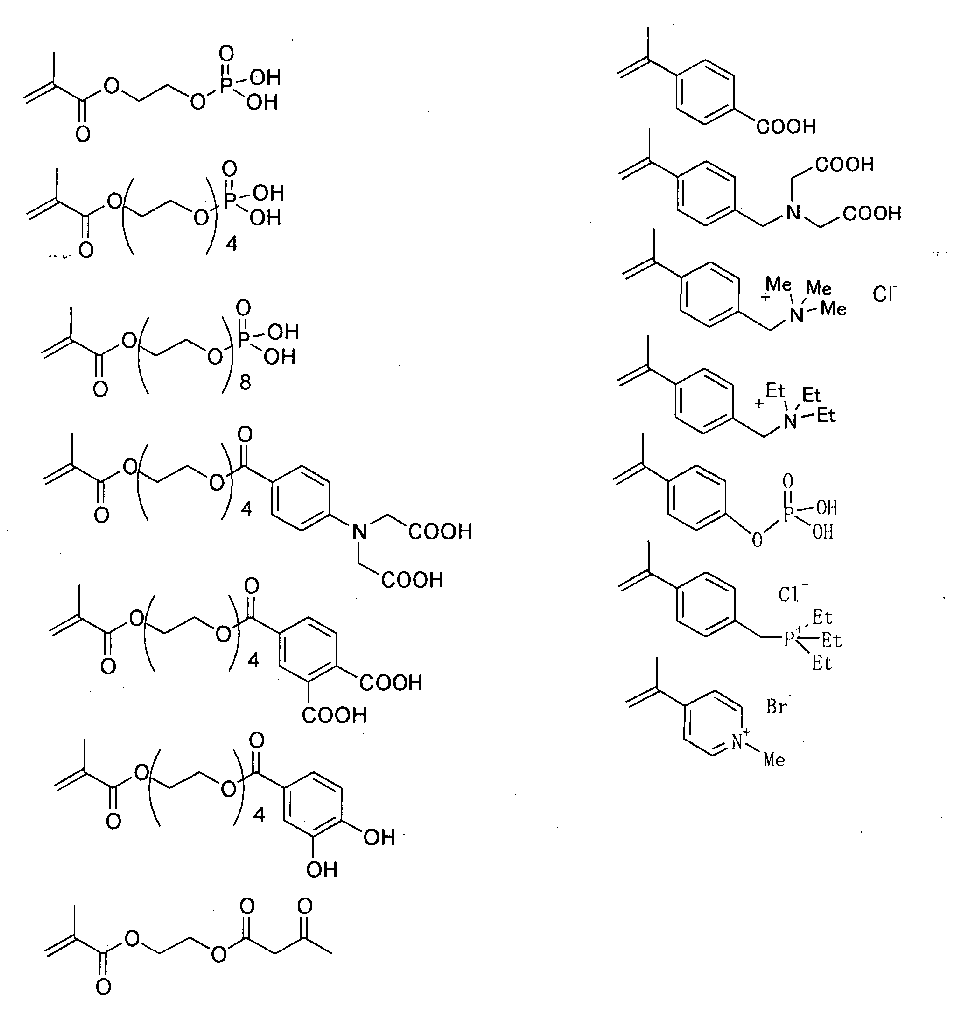

As the hydrophilic groups of polymer resins for undercoating that can be used in the invention, e.g., a hydroxyl group, a carboxyl group, a carboxylate group, a hydroxyethyl group, a polyoxyethyl group, a hydroxypropyl group, a polyoxypropyl group, an amino group, an aminoethyl group, an aminopropyl group, an ammonium group, an amido group, a carboxymethyl group, a sulfonic acid group, a phosphoric acid group, etc., are preferably exemplified. Monomers having a sulfonic acid group showing high hydrophilicity are preferred above all. As the specific examples of the monomers having a sulfonic acid group, sodium salts and amine salts of methallyloxybenzenesulfonic acid, allyloxybenzenesulfonic acid, allylsulfonic acid, vinylsulfonic acid, allylsulfonic acid, p-styrenesulfonic acid, methallylsulfonic acid, acrylamido-t-butylsulfonic acid, 2-acrylamido-2-methyl- propanesulfonic acid, or (3-acryloyloxypropyl)butylsulfonic acid are exemplified. Of these monomers, in view of a hydrophilic performance and handling property in synthesis, sodium salt of 2-acrylamido-2-methylpropanesulfonic acid is preferred.

It is preferred for the water-soluble polymer resins for the undercoat layer in the invention to have a crosslinking group. Adhesion of the undercoat layer to an image part can be heightened on account of a crosslinking group. For giving a crosslinking property to a polymer resin for the undercoat layer, it is effective to introduce a crosslinking functional group, e.g., an ethylenic unsaturated bond, to the side chain of the polymer, and to form a salt structure by a substituent having counter charge of the polar substituent of the polymer resin and a compound having an ethylenic unsaturated bond.

As the examples of polymers having an ethylenic unsaturated bond in the side chain of the molecule, ester or amide polymers of an acrylic acid or methacrylic acid, wherein the residue of the ester or amide (R of -COOR or -CONHR) has an ethylenic unsaturated bond, are exemplified.

The examples of the residues having an ethylenic unsaturated bond (the above R) include -(CH₂)ₙCR₁=CR₂R_{3,} -(CH₂O)ₙCH₂CR₁=CR₂R_{3,} -(CH₂CH₂O)ₙCH₂CR₁=CR₂R₃, -(CH₂)ₙNH-CO-O- CH₂CR₁=CR₂R₃, -(CH₂)ₙ-O-CO-CR₁=CR₂R_{3,} and -(CH₂CH₂O)₂-X (in the formulae, R₁, R₂ and R₃ each represents a hydrogen atom, a halogen atom, an alkyl group having from 1 to 20 carbon atoms, an aryl group, an alkoxyl group or an aryloxy group, and R₁ and R₂ or R₃ may be bonded to each other to form a ring, n represents an integer of from 1 to 10, and X represents a dicyclopentadienyl residue). The specific examples of the ester residues include -CH₂CH=CH₂ (disclosed in JP-B-7-21633), -CH₂CH₂O-CH₂CH=CH₂, -CH₂C(CH₃)=CH₂, -CH₂CH=CH-C₆H₅, -CH₂CH₂OCOCH=CH-C₆H₅, -CH₂CH₂NHCOO-CH₂CH=CH₂, and -CH₂CH₂O-X (wherein X represents a dicyclopentadienyl residue). The specific examples of the amido residues include -CH₂CH=CH₂, -CH₂CH₂-Y (wherein Y represents a cyclohexene residue), and -CH₂CH₂OCO-CH=CH₂. As the monomers having a crosslinking group of the polymer resins for the undercoat layer, the above esters or amides of acrylic acid or methacrylic acid having a crosslinking group are preferred.

The content of crosslinkable groups in the polymer resin for the undercoat layer (the content of radical polymerizable unsaturated double bonds by the iodometric titration method) is preferably from 0.1 to 10.0 mmol per gram of the polymer resin, more preferably from 1.0 to 7.0 mmol, and most preferably from 2.0 to 5.5 mmol. The compatibility of good sensitivity with soiling resistance, and good preservation stability can be obtained in this range of the crosslinkable groups.

Polymer resins for the undercoat layer have a mass average molecular weight of preferably 5,000 or higher, more preferably from 10,000 to 300,000, and a number average molecular weight of preferably 1,000 or higher, more preferably from 2,000 to 250,000. The degree of polydispersion (mass average molecular weight/number average molecular weight) is preferably from 1.1 to 10. The polymer resins for the undercoat layer may be any of a random polymer, a block polymer and a graft polymer, but a random polymer is preferred.

As the polymer resins for the undercoat layer, known resins having a hydrophilic group can also be used. The specific examples of such resins include gum arabic, casein, gelatin, starch derivatives, carboxymethyl cellulose and the sodium salt thereof, cellulose acetate, sodium alginate, vinyl acetate-maleic acid copolymers, styrene-maleic acid copolymers, polyacrylic acids and the salts thereof, polymethacrylic acids and the salts thereof, homopolymers and copolymers of hydroxyethyl methacrylate, homopolymers and copolymers of hydroxyethyl acrylate, homopolymers and copolymers of hydroxypropyl methacrylate, homopolymers and copolymers of hydroxypropyl acrylate, homopolymers and copolymers of hydroxybutyl methacrylate, homopolymers and copolymers of hydroxybutyl acrylate, polyethylene glycols, hydroxypropylene polymers, polyvinyl alcohols, hydrolyzed polyvinyl acetate having the degree of hydrolysis of 60 mol% or more, preferably 80 mol% or more, polyvinyl formal, polyvinyl butyral, polyvinyl pyrrolidone, homopolymers and copolymers of acrylamide, homopolymers and polymers of methacrylamide, homopolymers and copolymers of N-methylol- acrylamide, polyvinyl pyrrolidone, alcohol-soluble nylon, and polyether of 2,2-bis(4-hydroxyphenyl)propane and epichlorohydrin.

The polymer resins for the undercoat layer may be used alone, or two or more resins may be used as mixture. The polymer resins for the undercoat layer is dissolved in a solvent and used as an undercoat layer coating solution. Any solvents can be used so long as they can dissolve or disperse the polymer resins for undercoating and can be evaporated in a drying process after coating. For example, the solvents that are used in forming an image-recording layer can be used. The content of the resin in an undercoat layer coating solution is preferably from 0.01 to 20 mass%. The coating amount of the undercoat layer (solids content) is preferably from 0.1 to 100 mg/m², and more preferably from 1 to 30 mg/m².

### <Protective layer>

In the lithographic printing plate precursor of the invention, for the purpose of giving an oxygen-excluding property, preventing the generation of scratches on an image-recording layer, and preventing ablation at the time of exposure with high intensity laser, if necessary, a protective layer (an overcoat layer) may be provided on an image-recording layer. Exposure process of a lithographic printing plate is generally carried out in the air. Low molecular weight compounds such as oxygen and basic substance present in the air hinder the image forming reaction that occurs in an image-recording layer by exposure process. The protective layer prevents the low molecular weight compounds such as oxygen and basic substance from mixing into the image-recording layer, as a result inhibits hindering reaction of image formation in the air. Accordingly, the characteristics required of the protective layer are to lower the permeability of low molecular weight compounds such as oxygen, to have good transmittance of light used for exposure, to be excellent in adhesion with the image-recording layer, and capable of being eliminated easily in the on-press development process after exposure. Overcoat layers having such characteristics are disclosed in, e.g., U.S. Patent 3,458,311 and JP-B-55-49729.

As the materials for use in the protective layer, any of water-soluble polymers and water-insoluble polymers can be arbitrarily selected and used. Specifically, for example, water-soluble polymers, e.g., polyvinyl alcohol, modified polyvinyl alcohol, polyvinyl pyrrolidone, polyvinyl imidazole, polyacrylic acid, polyacrylamide, a partial saponification product of polyvinyl acetate, ethylene-vinyl alcohol copolymers, water-soluble cellulose derivatives, gelatin, starch derivatives, gum arabic, etc., and polymers, e.g., polyvinylidene chloride, poly(meth)acrylonitrile, polysulfone, polyvinyl chloride, polyethylene, polycarbonate, polystyrene, polyamide, cellophane, etc. can be exemplified. These polymers can also be used in combination of two or more, if necessary. As relatively useful materials of the above polymers, water-soluble polymer compounds excellent in crystallizability are exemplified, and specifically polyvinyl alcohol, polyvinyl pyrrolidone, polyvinyl imidazole, water- soluble acrylic resins, e.g., polyacrylic acid, etc., gelatin, gum arabic, etc., are preferred, and from the aspects of capable of coating with water as the solvent and capable of being easily removed with a fountain solution in printing, polyvinyl alcohol, polyvinyl pyrrolidone and polyvinyl imidazole are preferred. Of these polymers, polyvinyl alcohol (PVA) gives the best results to fundamental characteristics such as oxygen exclusion and removal by development.

Polyvinyl alcohols that can be used for the protective layer may be partially substituted with ester, ether and acetal so long as they contain a substantial amount of unsubstituted vinyl alcohol units having necessary water solubility. A part of the polyvinyl alcohols may also contain other copolymer components. For example, polyvinyl alcohols of various polymerization degrees randomly having a variety of hydrophilic modified sites such as anion modified site modified with an anion, e.g., a carboxyl group, a sulfo group, etc., a cation modified site modified with a cation, e.g., an amino group, an ammonium group, etc., a silanol modified site, a thiol modified site, etc.; and polyvinyl alcohols of various polymerization degrees having at polymer chain terminals a variety of modified sites such as ester modified sites of the above anion modified site, cation modified site, silanol modified site, thiol modified site, further an alkoxyl modified site, a sulfide modified site, or vinyl alcohol with various organic acids, ester modified sites of the above anion modified site with alcohols, etc., an epoxy modified site, etc., are also preferably used. These modified polyvinyl alcohols are preferably compounds hydrolyzed by 71 to 100% and having polymerization degree of the range of from 300 to 2,400. Specifically, the examples include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613, and L-8 (manufactured by Kuraray Co., Ltd.). Further, as modified polyvinyl alcohols, KL-318, KL-118, KM-618, KM-118 and SK-5102 having an anion modified site, C-318, C-118 and CM-318 having a cation modified site, M-205 and M-115 having a terminal thiol modified site, MP-103, MP-203, MP-102 and MP-202 having a terminal sulfide modified site, HL-12E and HL-1203 having a modified site of ester with higher fatty acid at terminals, and R-1130, R-2105, R-2130 having a reactive silane modified site are exemplified.

It is also preferred that the protective layer contains a layered compound. The layered compound is a particle in the thin tabular shape and, for example, a mica group, such as natural mica and synthetic mica represented by the following formula, A(B, C)₂₋₅D₄O₁₀(OH, F, O)₂ (wherein A represents any of Li, K, Na, Ca, Mg and an organic cation, B and C represent any of Fe(II), Fe(III), Mn, Al, Mg and V, and D represents Si or Al), and talc, taeniolite, montmorillonite, saponite, hectorite and zirconium phosphate represented by formula 3MgO·4SiO·H₂O are exemplified.

The examples of natural micas include muscovite, paragonite, phlogopite, biotite and lepidolite. The examples of synthetic micas include non-swellable micas, e.g., fluorine phlogopite KMg₃(AlSi₃O₁₀)F₂ and potassium tetrasilicate mica KMg_{2.5}(Si₄O₁₀)F₂, etc., and swellable micas, for example, Na tetrasililic mica NaMg_{2.5}(Si₄O₁₀)F₂, Na or Li taeniolite (Na, Li)Mg₂Li(Si₄O₁₀)F₂, and montmorillonite series Na or Li hectorite (Na, Li)_{1/8}Mg_{2/5}Li_{1/8}(Si₄O₁₀)F₂, etc. Synthetic smectites are also useful. Of these layered compounds described above, fluorine-based swellable micas, which are synthetic layered compounds, are especially useful. That is, these micas and swellable clay minerals, e.g., montmorillonite, saponite, hectorite, bentonite, etc., have a lamination structure comprising unit crystal lattice layers having a thickness of from 10 to 15 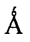 or so, and metallic atom substitution in the lattice is extremely great as compared with other clay minerals. As a result, there is an insufficient quantity of positive electric charge in the lattice layers, and cations of organic cations such as Li⁺, Na⁺, Ca²⁺, Mg²⁺, amine salt, quaternary ammonium salt, phosphonium salt and sulfonium salt are adsorbed among layers to compensate for the insufficiency. These layered compounds swell with water. When shear is applied in the swollen state, the lattices easily cleave and form stable sol in water. Bentonite and swellable synthetic micas have the marked tendency.

In connection with the shape of the layered compounds, the thickness is the thinner the better from the viewpoint of the control of diffusion, and the plane size is the bigger the better so long as the smoothness of the coated surface and the transmission of actinic rays are not hindered. Accordingly, the aspect ratio of layered compounds is preferably 20 or higher, preferably 100 or higher, and especially preferably 200 or higher. The aspect ratio is the ratio of the thickness to the long diameter of a particle, and this can be measured, for example, from the projection drawing of the microphotograph of a particle. The greater the aspect ratio, the greater is the effect obtained. The average diameter of the particle of layered compounds is from 1 to 20 µm, preferably from 1 to 10 µm, and especially preferably from 2 to 5 vm. When the particle size is smaller than 1 µm, the control of permeation of oxygen and moisture is insufficient, so that sufficient effect cannot be revealed. While when the particle size is greater than 20 µm, dispersion stability in a coating solution is insufficient, so that stable coating cannot be done. The average thickness of the particle is 0.1 µm or less, preferably 0.05 µm or less, and especially preferably 0.01 µm or less. For instance, of the inorganic layered compounds, the thickness of swellable synthetic mica, which is a representative compound, is from 1 to 50 nm, and the plane size is from 1 to 20 µm or so. When the particles of inorganic layered compounds having such a high aspect ratio are contained in a protective layer, the film strength is improved and the permeation of oxygen and moisture can be effectively prevented, hence the deterioration of the overcoat layer due to deformation and the like can be restrained. Therefore, even when the lithographic printing plate precursor is preserved under a high moisture condition for a long period of time, the lithographic printing plate precursor is free from the degradation of image-forming property due to the change in moisture, and excellent preservation stability can be ensured.

An inorganic layered compound contained in a protective layer is preferably in the proportion of from 5/1 to 1/100 in the mass ratio to the amount of the binder used in the overcoat layer. Even when a plurality of inorganic layered compounds are used in combination, it is preferred that the total amount of these inorganic layered compounds be within the above mass ratio.

As other compositions of the protective layer, by the addition of glycerol, dipropylene glycol, etc., in an amount of several mass% to a (co)polymer, flexibility can be given. Further, an anionic surfactant, e.g., sodium alkylsulfate, sodium alkylsulfonate, etc.; an amphoteric surfactant, e.g., alkylaminocarboxylate, alkylaminodicarboxylate, etc.; and a nonionic surfactant, e.g., polyoxyethylene alkyl phenyl ether, etc., can be added. These surfactants can be used in an amount of from 0.1 to 100 mass% based on the (co)polymer. For the improvement of adhesion with an image part, there are disclosed, e.g., in JP-A-49-70702 and British Patent Application 1,303,578 that sufficient adhesion can be obtained by mixing from 20 to 60 mass% of an acrylic emulsion, a water-insoluble vinylpyrrolidone-vinyl acetate copolymer, etc., to a hydrophilic polymer primarily comprising polyvinyl alcohol, and laminating the resulting mixture on an image-recording layer. Any of these known techniques can be used in the invention.

Other functions can be given to the protective layer. For example, by the addition of a colorant excellent in transmission of infrared rays used for exposure and capable of efficiently absorbing rays of other wavelengths (e.g., the water-soluble dyes in the invention), safelight aptitude can be improved without causing reduction of sensitivity.

General methods of dispersing a layered compound for use in the protective layer are described below. In the first place, from 5 to 10 mass parts of a swellable layered compound exemplified above as preferred example is added to 100 mass parts of water to be made thoroughly intimate with water to swell, and then dispersed with a disperser. As the dispersers used here, various kinds of mills of directly applying force mechanically to effect dispersion, high speed stirring type dispersers having great shearing force, and dispersers giving ultrasonic energy of high strength and the like are exemplified. Specifically, a ball mill, a sand grinder mill, a visco mill, a colloid mill, a homogenizer, a dissolver, a POLYTRON, a homomixer, a homoblender, a KD mill, a JET AJITER, a capillary emulsifier, a liquid siren, an electromagnetic distortion type ultrasonic wave generator, an emulsifier having a Poleman whistle and the like are exemplified. The dispersion containing 5 to 10 mass % parts of inorganic layered compound dispersed by the above method is highly viscous or gel and very excellent in preservation stability. When a protective layer coating solution is prepared by using the dispersion, it is preferred to dilute the dispersion with water and thoroughly stir, and then blend with a binder solution.

To the protective layer coating solution can be added known additives such as an anionic surfactant, a nonionic surfactant, a cationic surfactant, and a fluorine surfactant to improve coating stability, and a water-soluble plasticizer to improve physical properties of the film. As water-soluble plasticizers, e.g., propionamide, cyclohexanediol, glycerol, sorbitol, etc., are exemplified. Further, a water-soluble (meth)acrylic polymer can be added. In addition, known additives may be added to the coating solution in order to improve the adhesion with an image-recording layer and aging stability of the coating solution.

By coating the thus prepared overcoat layer coating solution on the image-recording layer provided on a support and drying, an overcoat layer is formed. A coating solvent can be arbitrarily selected in connection with the binder, and when a water-soluble polymer is used, it is preferred to use distilled water and purified water as the coating solvent. The concentration of the solids content in the overcoat layer coating solution is preferably from 0.1 to 30 mass%. The coating method of the overcoat layer is not especially restricted and known methods, e.g., the methods disclosed in U.S. Patent 3,458,311 and JP-B-55-49729 can be used. Specifically, the overcoat layer is coated, for example, by a blade coating method, an air knife coating method, a gravure coating method, a roll coating method, a spray coating method, a dip coating method, or a bar coater coating method.

The coating amount of the overcoat layer is preferably from 0.01 to 10 g/m² in dry weight, more preferably from 0.02 to 3 g/m², and most preferably from 0.02 to 1 g/m².

### [Lithographic Printing Method]

In the invention, by exposing the image-recording layer formed by coating on the support through a transparent original having a line image and a dot image, or by imagewise exposing with a laser by digital data, a relief image negative to the original is given. As preferred light sources for exposure, a carbon arc lamp, a mercury lamp, a xenon lamp, a metal halide lamp, a stroboscope, ultraviolet rays, infrared rays, and laser beams are exemplified. Laser beams are especially preferred, and a solid state laser and a semiconductor laser radiating infrared rays of from 760 to 1,200 nm, and a semiconductor laser radiating rays of from 250 to 420 nm are exemplified. Infrared lasers for use in the invention are preferably those capable of outputting 100 mW or more. For shortening exposure time, it is preferred to use a multi-beam laser device. The exposure time per a pixel is preferably not longer than 20 µsec. The quantity of irradiation energy is preferably from 10 to 300 mJ/cm².

In the lithographic printing method in the invention, as described above, after the lithographic printing plate precursor of the invention is imagewise exposed, printing is carried out by supplying printing ink and a fountain solution without being subjected to development process. Specifically, a method of subjecting a lithographic printing plate precursor to exposure with laser beams, and then mounting the exposed printing plate precursor on a printing press without undergoing development process and performing printing, and a method of mounting a lithographic printing plate precursor on a printing press, and then exposing the printing plate precursor with laser beams on the printing press, and performing printing without subjecting to development process are exemplified.

When a lithographic printing plate precursor is imagewise exposed with laser beams and then printing is performed by supplying printing ink and a fountain solution without development process such as wet development process, the image-recording layer hardened by exposure forms a printing ink-receiving part having an ink-receptive surface at the exposed part of the image-recording layer. On the other hand, the unhardened image-recording layer is dissolved with the supplied fountain solution or printing ink or both of them and removed at the unexposed part, and a hydrophilic surface is bared at that part. As a result, the fountain solution adheres to the bared hydrophilic surface, the printing ink adheres to the image-recording layer in the exposed part, and printing is started. Here, the one supplied first to the printing plate may be a fountain solution or may be printing ink. In this manner, a lithographic printing plate precursor is subjected to on-press development on an offset press and used as it is in printing of a plenty of sheets.

### EXAMPLE

The invention will be described in detail with reference to examples, but the invention is not limited thereto.

### EXAMPLES 1 TO 25 AND COMPARATIVE EXAMPLES 1 TO 4

### 1. Manufacture of lithographic printing plate precursor (1):

### (1) Manufacture of a support:

For removing the rolling oil on the surface of an aluminum plate having a thickness of 0.3 mm (material 1050), the aluminum plate was subjected to degreasing treatment with a 10 mass% sodium aluminate aqueous solution at 50°C for 30 seconds, and then the aluminum surface was subjected to graining with three nylon brushes planted with hairs having a hair diameter of 0.3 mm and a suspension of pumice of a median diameter of 25 µm and water (the specific gravity: 1.1 g/cm³), and then the surface of the aluminum plate was thoroughly washed with water. The plate was immersed in a 25 mass% sodium hydroxide aqueous solution of 45°C for 9 seconds for etching, and washed with water. After washing with water, the plate was further immersed in a 20 mass% nitric acid aqueous solution of 60°C for 20 seconds, followed by washing with water. The etched amount of the surface by graining was about 3 g/m².

In the next place, electrochemical surface roughening treatment was performed continuously by alternating voltage of 60 Hz. The electrolyte at this time was an aqueous solution containing 1 mass% of a nitric acid (containing 0.5 mass% of an aluminum ion) and the liquid temperature was 50°C. As the alternating current electric source waveform, trapezoidal rectangular wave alternating current was used, the time TP required for the electric current value to reach the peak from zero was 0.8 msec; the duty ratio was 1/1, and electrochemical surface roughening treatment was performed with a carbon electrode as the counter electrode. Ferrite was used as the auxiliary anode. The electric current density was 30 A/dm² at a peak value of electric current, and 5% of the electric current from the electric source was diverted to the auxiliary anode. The quantity of electricity in the nitric acid electrolysis was the quantity of electricity at the time with the aluminum plate as the anode of 175 C/dm². The aluminum plate was then washed with water by spraying.

Subsequently, electrochemical surface roughening treatment of the aluminum plate was performed with an electrolyte containing a 0.5 mass% hydrochloric acid aqueous solution (containing 0.5 mass% of an aluminum ion) at a liquid temperature of 50°C on the condition of the quantity of electricity at the time with the aluminum plate as the anode of 50 C/dm² in the same manner as in the above nitric acid electrolysis. The plate was then washed with water by spraying. The plate was provided with 2.5 g/m² of a direct current anodic oxide film with a 15 mass% sulfuric acid (containing 0.5 mass% of an aluminum ion) as the electrolyte and by the electric current density of 15 A/dm², and then washed and dried. The central line average roughness (Ra) of the plate measured with a needle having a diameter of 2 µm was 0.51 µm.

The following undercoat layer coating solution (1) was coated on the aluminum plate in a dry coating weight of 10 mg/m² to prepare a support for use in the following test.

### <Undercoat layer coating solution (1)>

| | |
|---|---|
| • The following polymer resin (1) for undercoating | 0.017 g |
| • Methanol | 9.00 g |
| • Distilled water | 1.00 g |

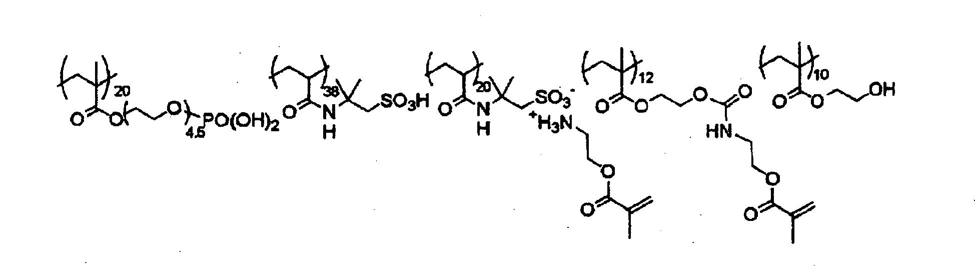

Weight average molecular weight: 30,000
Polymer resin (1) for undercoating

### (2) Formation of an image-recording layer:

Image-recording layer coating solution (1) having the composition shown below was coated on the above support by bar coating, dried in an oven at the temperature and time respectively shown in Table 1 below to form an image-recording layer having a dry coating weight of 1.0 g/m², whereby a lithographic printing plate precursor was obtained. Image- recording layer coating solution (1) was obtained by mixing and stirring immediately before coating photosensitive solution (1) shown below and microgel solution (1) shown below.

| <Photosensitive solution (1)> | |
|---|---|
| • Binder polymer shown in Table 1 below | 0.162 g |
| • Polymerization initiator (1) shown below | Amount is shown in Table 1 |
| • Infrared absorber (1) shown below | 0.020 g |
| • Polymerizable compound (ARONIX M215, manufactured by Toa Gosei Co., Ltd.) | 0.385 g |
| • Low molecular weight hydrophilic compound (1) shown below | Amount is shown in Table 1 |
| • Fluorine surfactant (1) shown below | Amount is shown in Table 1 |
| • Methyl ethyl ketone | 1.091 g |
| • 1-Methoxy-2-propanol | 8.609 g |

| <Microgel solution (1)> | |
|---|---|
| • Microgel (1) synthesized as shown below | 2.640 g |
| • Distilled water | 2.425 g |

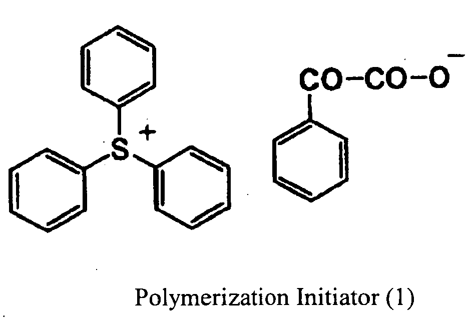

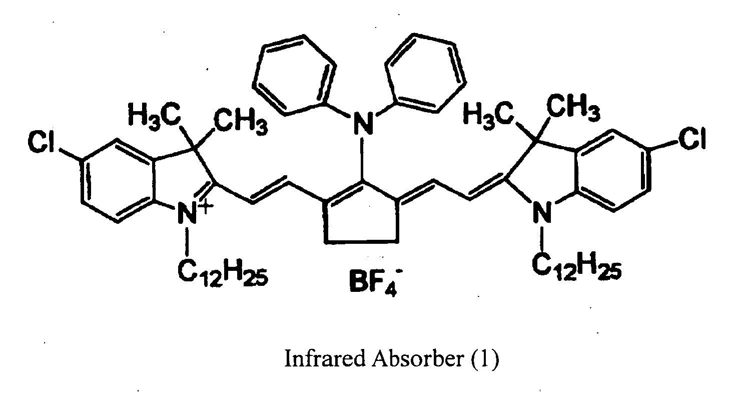

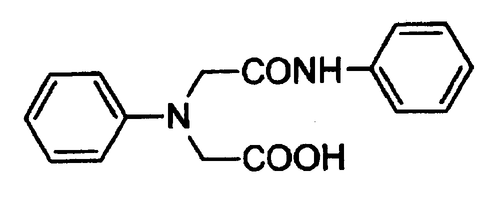

Low Molecular Weight Hydrophilic Compound (1)

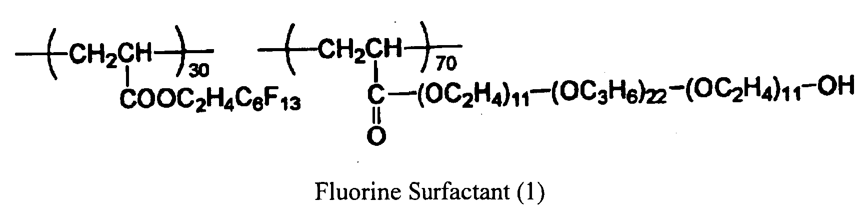

### (Synthesis of microgel (1))

As the oil phase component, 10 g of the addition product of trimethylolpropane and xylene diisocyanate (Takenate D-110N, manufactured by Mitsui Takeda Chemicals Inc.), 3.15 g of pentaerythritol triacrylate (SR444 manufactured by Nippon Kayaku Co., Ltd.), and 0.1 g of Pionin A-41C (manufactured by Takemoto Oil & Fat) were dissolved in 17 g of ethyl acetate. As the aqueous phase component, 40 g of a 4 mass% aqueous solution of PVA-205 was prepared. The oil phase component and the aqueous phase component were mixed, and emulsified with a homogenizer at 12,000 rpm for 10 minutes. The obtained emulsified product was added to 25 g of distilled water, stirred at room temperature for 30 minutes, and then stirred at 50°C for 3 hours. The microgel solution thus obtained was diluted with distilled water to make the concentration of solids content 15 mass%. The average particle size was 0.2 µm.

### (3) Formation of protective layer:

A protective layer coating solution having the composition shown below was further coated on the above image-recording layer by bar coating, dried at 120°C for 60 seconds in an oven to form a protective layer having a dry coating weight of 0.15 g/m², whereby a lithographic printing plate precursor (1) for use in Examples 1 to 8 and Comparative Example 1 was obtained.

### <Protective layer coating solution>

| | |
|---|---|
| • Inorganic particle dispersion (1) prepared as follows | 1.5 g |
| • Polyvinyl alcohol (POVAL PVA 105) (degree of saponification: 98 to 99 mol%, degree of polymerization: 500, manufactured by Kuraray Co., Ltd.) | 0.06 g |
| • Polyvinyl pyrrolidone (K30, weight average molecular weight: 400,000, manufactured by Wako Pure Chemical Industries) | 0.01 g |
| • Copolymer of vinylpyrrolidone and vinyl acetate (LUVITEC VA64W, copolymerization ratio: 6/4, manufactured by ICP Electronics Inc.) | 0.01 g |
| • Nonionic surfactant (trade name: EMALEX710, manufactured by Nihon Emulsion Co., Ltd.) | 0.01 g |
| • Ion exchange water | 6.0 g |

### (Preparation of inorganic particle dispersion (1))

To 193.6 g of ion exchange water was added 6.4 g of synthetic mica Somasif ME-100 (manufactured by CO-OP CHEMICAL CO., LTD.), and the mixture was dispersed with a homogenizer until the average particle size (a laser scattering method) reached 3 µm. The aspect ratio of the obtained inorganic particle dispersion was 100 or more.

### 2. Manufacture of lithographic printing plate precursor (2):

Lithographic printing plate precursor (2) for use in Examples 9 to 16 and Comparative Example 2 was obtained in the same manner as in the manufacture of lithographic printing plate precursor (1), except that image-recording layer coating solution (1) described in the manufacture of lithographic printing plate precursor (1) was changed to image-recording layer coating solution (2) having the composition shown below, and drying condition of the image-recording layer was changed as shown in Table 1.

### <Image-recording layer coating solution (2)>

| | |
|---|---|
| • Infrared absorber (2) shown below | 0.05 g |
| • Polymerization initiator (1) shown above | Amount is shown in Table 1 |
| • Binder polymer shown in Table 1 | 0.50 g |
| • Polymerizable compound (ARONIX M-215, manufactured by Toa Gosei Co., Ltd.) | 1.00 g |
| • Naphthalenesulfonate of Victoria Pure Blue | 0.02 g |
| • Low molecular weight hydrophilic compound (1) shown above | Amount is shown in Table 1 |
| • Fluorine surfactant (1) shown above | Amount is shown in Table 1 |
| • Methyl ethyl ketone | 18.0 g |

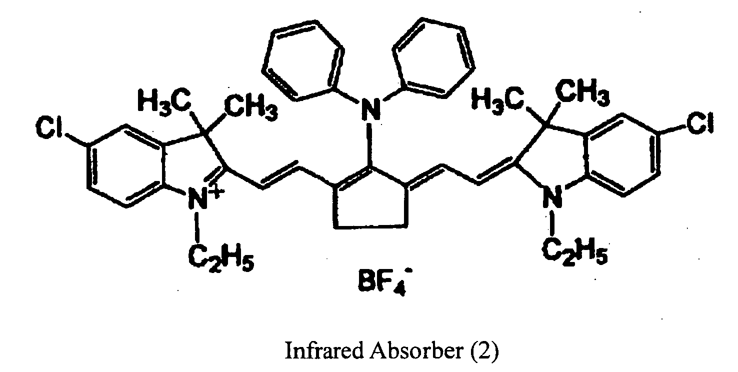

### 3. Manufacture of lithographic printing plate precursor (3):

Lithographic printing plate precursor (3) for use in Examples 17 to 22 was obtained in the same manner as in the manufacture of lithographic printing plate precursor (1), except that image-recording layer coating solution (1) described in the manufacture of lithographic printing plate precursor (1) was changed to image-recording layer coating solution (3) having the composition shown below, and drying condition of the image-recording layer was changed as shown in Table 1. Image-recording layer coating solution (3) was obtained by mixing and stirring immediately before coating photosensitive solution (2) shown below and microcapsule solution (1) shown below.

### <Photosensitive solution (2)>

| | |
|---|---|
| • Polymerization initiator (1) shown above | Amount is shown in Table 1 |
| • Sensitizer (1) shown below | 1.00 g |
| • Binder polymer shown in Table 1 | 3.00 g |
| • Polymerizable compound (ARONIX M-315, manufactured by Toa Gosei Co., Ltd.) | 6.20 g |
| • Leuco Crystal Violet | 3.00 g |
| • Thermal polymerization inhibitor (N-nitrosophenylhydroxylamine aluminum salt) | 0.10 g |
| • Low molecular weight hydrophilic compound (1) shown above | Amount is shown in Table 1 |
| • Fluorine surfactant (1) shown above | Amount is shown in Table 1 |
| • Methyl ethyl ketone | 35.00 g |
| • 1-Methoxy-2-propanol | 35.00 g |

| <Microcapsule solution (1)> | |
|---|---|
| • Microcapsule (1) synthesized as shown below | 10.00 g |
| • Distilled water | 10.00 g |

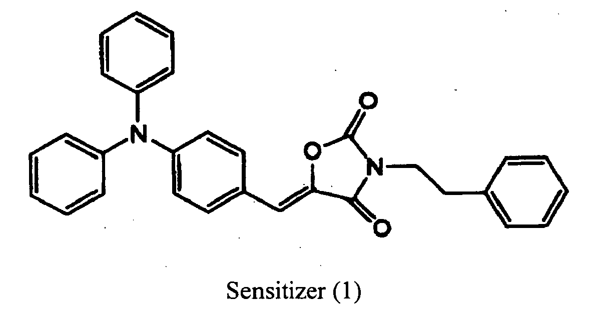

### (Synthesis of microcapsule (1))

As the oil phase component, 10 g of the addition product oftrimethylolpropaneand xylene diisocyanate (Takenate D-110N, manufactured by Mitsui Takeda Chemicals Inc.), 3.15 g of pentaerythritol triacrylate (SR444 manufactured by Nippon Kayaku Co., Ltd.), 1 g of 3-(N,N-diethylamirio)-6-methyl-7- anilinofluoran (ODB, manufactured by Yamamoto Chemicals Inc.), and 0.1 g of Pionin A-41C (manufactured by Takemoto Oil & Fat) were dissolved in 17 g of ethyl acetate. As the aqueous phase component, 40 g of a 4 mass% aqueous solution of PVA-205 was prepared. The oil phase component and the aqueous phase component were mixed, and emulsified with a homogenizer at 12,000 rpm for 10 minutes. The obtained emulsified product was added to 25 g of distilled water, stirred at room temperature for 30 minutes, and then stirred at 40°C for 3 hours. The microcapsule solution thus obtained was diluted with distilled water to make the concentration of solids content 20 mass%. The average particle size was 0.25 µm.

### 4. Manufacture of lithographic printing plate precursor (4):

Lithographic printing plate precursor (4) for use in Examples 23 to 25 and Comparative Examples 3 and 4 was obtained in the same manner as in the manufacture of lithographic printing plate precursor (1), except that image-recording layer coating solution (1) described in the manufacture of lithographic printing plate precursor (1) was changed to image-recording layer coating solution (4) having the composition shown below, and drying condition of the image-recording layer was changed as shown in Table 1.

### <Image-recording layer coating solution (4)>

| | |
|---|---|
| • Water | 71.7 g |
| • Microcapsule (2) synthesized as shown below | 33.3 g |
| • Polymerization initiator (1) shown above | Amount is shown in Table 1 |
| • Fluorine surfactant (1) shown above | Amount is shown in Table 1 |

### <Synthesis of microcapsule (2)>

As the oil phase component, 5 g of the addition product of trimethylolpropane and xylene diisocyanate (Takenate D-110N, manufactured by Mitsui Takeda Chemicals Inc.), 3.15 g of ARONIX M-315 (manufactured by Toa Gosei Co., Ltd.), 0.35 g of infrared absorber (2) shown above, 1 g of 3-(N,N- diethylamino)-6-methyl-7-anilinofluoran (ODB, manufactured by Yamamoto Chemicals Inc.), and 0.1 g of Pionin A-41C (manufactured by Takemoto Oil & Fat) were dissolved in 17 g of ethyl acetate. As the aqueous phase component, 40 g of a 4 mass% aqueous solution of PVA-205 was prepared. The oil phase component and the aqueous phase component were mixed, and emulsified with a homogenizer at 12,000 rpm for 10 minutes. The obtained emulsified product was added to 25 g of distilled water, stirred at room temperature for 30 minutes, and then stirred at 40°C for 3 hours. The microcapsule solution thus obtained was diluted with distilled water to make the concentration of solids content 15 mass%. The average particle size was 0.2 µm.

### 1. Measurement of adhesion of image-recording layer and support:

The adhesion of the image-recording layer and the support of each of the manufactured lithographic printing plate precursors was measured according to the method described above. The results obtained are shown in Table 2 below.

### 2. Observation of development behavior:

Each of these lithographic printing plate precursors was mounted on the cylinder of printing press SOR-M (manufactured by Heidelberg Japan K.K.) without being subjected to exposure and development, and whether film removal by falling out was occurring or whether the film was dissolving was observed according the method described above, and when the film was removed by falling out, the size of the fallen film in the horizontal direction was also measured. As the fountain solution, EU-3 (an etch, manufactured by Fuji Photo Film Co., Ltd.)/water/isopropyl alcohol = 1/89/10 (by volume) was used. The results obtained are shown in Table 2.

### 3. On-press developing property:

The obtained lithographic printing plate precursors (1), (2) and (4) were subjected to exposure with Trendsetter 3244VX (manufactured by Creo Products Incorporated) loading a water- cooling type 40 W infrared semiconductor laser on the conditions of output of 9 W, external drum rotation speed of 210 rpm, and resolution of 2,400 dpi, so that the exposed image contained a fine line chart. The obtained lithographic printing plate precursor (3) was subjected to exposure with a 375 nm semiconductor laser on the conditions of output of 2 mW, an external drum having a peripheral length of 900 mm, drum rotation speed of 800 rpm, and resolution of 2,400 dpi, so that the exposed image also contained a fine line chart. Each of the obtained exposed lithographic printing plate precursors was mounted on the cylinder of printing press SOR-M (manufactured by Heidelberg Japan K.K.) without being subjected to development. A fountain solution (EU-3 (an etch, manufactured by Fuji Photo Film Co., Ltd.)/water/isopropyl alcohol = 1/89/10 (by volume)) and TRANS-G (N) Sumi Ink (manufactured by Dainippon Ink and Chemicals Inc.) were fed as the fountain solution and ink, and 100 sheets of papers were printed at a printing speed of 6,000 sheets per hour. The number of the sheets required up to the time when on-press development of the unexposed part of the image-recording layer had been finished and until the state that the ink did not transfer to the printing paper was reached was measured and evaluated as the on-press developing property. As a result, the results shown in Table 2 were obtained.

### 4. Press life

After the on-press developing property was evaluated as described above, printing was further continued. With the increase of the number of printed papers, the image-recording layer gradually abraded and ink receptivity lowered, so that the density of ink on the printing paper decreased. Press life was evaluated by the number of sheets printed at the time when the ink density (reflection density) reduced by 0.1 from the starting time of printing. The results obtained are shown in Table 2.

### 5. Pollution of fountain solution:

After the above evaluation of press life, the state of pollution of the fountain solution on account of the components removed by development was observed and evaluated according to the following criteria. The results obtained are shown in Table 2.
A: Completely free from pollution
B: Slightly coloring alone was observed but on a tolerable level.
C: Distinctly colored and on an NG level.
D: Distinctly colored and scum was present.

**TABLE 1**

| Example | Formulation of Image-Recording Layer | | | | | Drying Condition of Image-Recording Layer | |
|---|---|---|---|---|---|---|---|
| | Coating Solution | Binder Polymer | Addition Amount of Polymerization Initiator (1) | Addition Amount of Fluorine Surfactant (1) | Low Molecular Weight Hydrophilic Compound (1) | Temperature | Time |
| Example 1 | (1) | (1) | 0.1 g | 0.044 g | None | 100°C | 120 sec. |
| Example 2 | (1) | (2) | 0.1 g | 0.044 g | None | 100°C | 120 sec. |
| Example 3 | (1) | (2) | 0.1 g | 0.1 g | None | 100°C | 120 sec. |
| Example 4 | (1) | (2) | 0.2 g | 0.1 g | None | 100°C | 120 sec. |
| Example 5 | (1) | (2) | 0.2 g | 0.1 g | None | 50°C | 60 sec. |
| Example 6 | (1) | (2) | 0.1 g | 0.044 g | 0.1 g | 50°C | 60 sec. |
| Example 7 | (1) | (3) | 0.1 g | 0.044 g | None | 100°C | 120 sec. |
| Example 8 | (1) | (3) | 0.1 g | 0.1 g | None | 50°C | 60 sec. |
| Example 9 | (2) | (1) | 0.1 g | 0.1 g | None | 100°C | 60 sec. |
| Example 10 | (2) | (1) | 0.2 g | 0.1 g | None | 100°C | 60 sec. |
| Example 11 | (2) | (2) | 0.1 g | 0.1 g | None | 100°C | 60 sec. |
| Example 12 | (2) | (2) | 0.2 g | 0.1 g | None | 100°C | 60 sec. |
| Example 13 | (2) | (2) | 0.1g | 0.1g | 0.1g | 100°C | 60 sec. |
| Example 14 | (2) | (2) | 0.2 g | None | 0.1g | 100°C | 60 sec. |
| Example 15 | (2) | (3) | 0.1 g | 0.1 g | None | 100°C | 60 sec. |
| Example 16 | (2) | (3) | 0.2 g | 0.1 g | None | 100°C | 60 sec. |
| Example 17 | (3) | (1) | 0.2 g | 0.1 g | None | 100°C | 120 sec. |
| Example 18 | (3) | (2) | 0.1 g | 0.1 g | None | 100°C | 120 sec. |
| Example 19 | (3) | (2) | 0.2 g | 0.1 g | None | 100°C | 120 sec. |
| Example 20 | (3) | (2) | 0.1 g | 0.1 g | 0.1 g | 100°C | 120 sec. ' |
| Example 21 | (3) | (3) | 0.1 g | 0.1 g | None | 100°C | 120 sec. |
| Example 22 | (3) | (3) | 0.2 g | 0.1 g | None | 100°C | 120 sec. |
| Example 23 | (4) | None | 0.5 g | 0.2 g | None | 80°C | 120 sec. |
| Example 24 | (4) | None | 0.3 g | 0.1 g | None | 80°C | 120 sec. |
| Example 25 | (4) | None | 0.5 g | 0.2 g | None | 65°C | 120 sec. |
| Comparative Example 1 | (1) | (4) | 0.1 g | 0.1 g | None | 100°C | 120 sec. |
| Comparative Example 2 | (2) | (4) | 0.1 g | 0.1 g | None | 100°C | 60 sec. |
| Comparative Example 3 | (4) | None | 0.2 g | None | None | 80°C | 120 sec. |
| Comparative Example 4 | (4) | None | 0.5 g | 0.2 g | None | 50°C | 120 sec. |

The binder polymers shown in Table 1 are as follows. 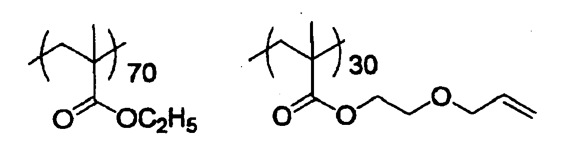 Binder Polymer (1)
Weight average molecular weight: 50,000 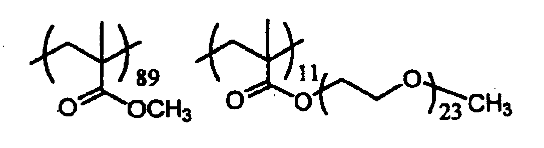 Binder Polymer (2)
Weight average molecular weight: 120,000 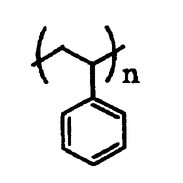 Binder Polymer (3)
Weight average molecular weight: 45,000 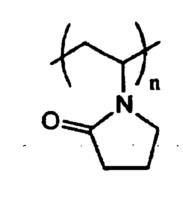 Binder Polymer (4)
Weight average molecular weight: 400,000
Polyvinylpyrrolidone K30 (Mw: 400,000, manufactured by Wako Pure Chemical Industries)

**TABLE 2**

| Example | Adhesion of Image-Recording Layer and Support (gf/10mm) | | Behavior of On-Press Development | Print Evaluation | | |
|---|---|---|---|---|---|---|
| | DRY Condition | WET Condition | | Number of Sheets by On-Press Development (number of sheets) | Press Life (ten thousand) | Pollution of Fountain Solution |
| Example 1 | 250 | 20 | Fallen out film (50 µm) | 15 | 2.0 | A |
| Example 2 | 300 | 20 | Fallen out film (50 µm) | 10 | 2.5 | A |
| Example 3 | 250 | 15 | Fallen out film (50 µm) | 10 | 2.0 | A |
| Example 4 | 250 | 15 | Fallen out film (40 µm) | 10 | 2.5 | A |
| Example 5 | 300 | 15 | Fallen out film (30 µm) | 20 | 2.0 | A |
| Example 6 | 250 | 5 | Fallen out film (40 µm) | 10 | 2.5 | A |
| Example 7 | 350 | 40 | Fallen out film (70 µm) | 20 | 2.0 | A |
| Example 8 | 300 | 30 | Fallen out film (60 µm) | 20 | 2.0 | A |
| Example 9 | 300 | 40 | Fallen out film (40 µm) | 20 | 1.5 | A |
| Example 10 | 250 | 25 | Fallen out film (50 µm) | 20 | 1.5 | A |
| Example 11 | 400 | 15 | Fallen out film (20 µm) | 15 | 2.0 | A |
| Example 12 | 350 | 5 | Fallen out film (40 µm) | 15 | 2.0 | A |
| Example 13 | 300 | 5 | Fallen out film (50 µm) | 10 | 2.0 | A |
| Example 14 | 350 | 5 | Fallen out film (30 µm) | 15 | 2.0 | A |
| Example 15 | 400 | 50 | Fallen out film (80 µm) | 20 | 2.0 | A |
| Example 16 | 350 | 40 | Fallen out film (100 µm) | 20 | 2.0 | A |
| Example 17 | 300 | 25 | Fallen out film (40 µm) | 15 | 1.5 | A |
| Example 18 | 350 | 25 | Fallen out film (40 µm) | 15 | 2.0 | A |
| Example 19 | 300 | 20 | Fallen out film (40 µm) | 10 | 1.5 | A |
| Example 20 | 350 | 15 | Fallen out film (50 µm) | 10 | 2.0 | A |
| Example 21 | 400 | 40 | Fallen out film (60 µm) | 20 | 1.5 | A |
| Example 22 | 350 | 30 | Fallen out film (50 µm) | 20 | 1.5 | A |
| Example 23 | 250 | 5 | Fallen out film (20 µm) | 10 | 1.5 | B |
| Example 24 | 250 | 15 | Fallen out film (40 µm) | 20 | 2.0 | A |
| Example 25 | 200 | 5 | Fallen out film (10 µm) | 10 | 1.0 | B |
| Comparative Example 1 | 300 | 5 | Dissolved | 10 | 0.1 | D |
| Comparative Example 2 | 250 | 5 | Dissolved | 15 | 0.1 | C |
| Comparative Example 3 | 350 | 300 | Development impossible | - | - | - |
| Comparative Example 4 | 200 | 5 | Dissolved | 10 | 0.1 | D |

As apparently seen from Table 2, the lithographic printing plate precursors in the invention (Examples 1 to 25) low in the adhesion of the image-recording layer and the support on WET condition, and are removed by falling out at the time of on-press development are excellent both in the on-press developing property and the press life as compared with conventional lithographic printing plate precursors (Comparative Examples 1 to 4), and further pollution of the fountain solution due to the components removed by on-press development is restrained.

While the invention has been described in detail and with reference to specific examples thereof, it will be apparent to one skilled in the art that various changes and modifications can be made therein without departing from the spirit and scope thereof. The present application is related to Japanese patent application filed on December 15, 2003 (Japanese Patent Application No. 2003-416541), Japanese patent application filed on April 28, 2004 (Japanese Patent Application No. 2004-133358), and Japanese patent application filed on January 31,2005 (Japanese Patent Application No. 2005-022605), and the disclosures of which are incorporated herein by reference.

### Industrial Applicability

The invention can provide a lithographic printing plate precursor capable of obtaining a plenty of sheets of good printed matters with practical energy dosage, which is excellent in on-press developing property and press life, and capable of reducing pollution of fountain solution, and the invention can also provide a lithographic printing method.

## Claims

1. A lithographic printing plate precursor, which comprises:
a support having provided thereon an image-recording layer,
wherein the lithographic printing plate precursor is mounted on a printing press and imagewise exposed, or mounted on the printing press after imagewise exposure, and then developed by feeding printing ink and/or a fountain solution, and
wherein at least a part of an unexposed part of the image-recording layer is not dissolved in the printing ink, the fountain solution or both of them, and removed by falling out of film.

2. The lithographic printing plate precursor according to claim 1,
wherein the image-recording layer comprises:
(A) an infrared absorber;
(B) a polymerization initiator; and
(C) a polymerizable compound.

3. The lithographic printing plate precursor according to claim 1,
wherein the image-recording layer comprises:
(B) a polymerization initiator; and
(C) a polymerizable compound, and has photosensitivity in a range of wavelengths of from 250 to 420 nm.

4. The lithographic printing plate precursor according to any one of claims 1 to 3,
wherein the image-recording layer comprises microcapsules or microgel.

5. The lithographic printing plate precursor according to any one of claims 1 to 4,
wherein the image-recording layer further comprises (D) a binder polymer that is insoluble in the printing ink, the fountain solution or both of them in a time required for the development process.

6. The lithographic printing plate precursor according to any one of claims 1 to 5,
wherein an adhesive force of the image-recording layer and the support lowers in the presence of the fountain solution.

7. A lithographic printing method, which comprises:
(i) a process of preparing the lithographic printing plate precursor according to any one of claims 1 to 6;
(ii) a process of mounting the lithographic printing plate precursor on a plate cylinder of a printing press and imagewise exposing, or mounting the lithographic printing plate precursor on the plate cylinder of the printing press after imagewise exposure;
(iii) a process of removing an unexposed part of the lithographic printing plate precursor after exposure by feeding printing ink and/or a fountain solution; and
(iv) a process of printing.

8. The lithographic printing method according to claim 7,
wherein, in the process (iii), at least a part of the unexposed part of the image-recording layer is removed by falling out with an inking roller of the printing press by feeding the printing ink and the fountain solution to the lithographic printing plate precursor after exposure.
